(19)

**Europäisches Patentamt**
**European Patent Office**
**Office européen des brevets**

(11) **EP 4 671 911 A1**

(12) **EUROPEAN PATENT APPLICATION**

(43) Date of publication:
**31.12.2025   Bulletin 2026/01**

(21) Application number: **25177640.7**

(22) Date of filing: **20.05.2025**

(51) International Patent Classification (IPC):
*G06F 1/10* (2006.01)      *H03B 5/18* (2006.01)
*H03B 5/20* (2006.01)

(52) Cooperative Patent Classification (CPC):
**G06F 1/10; H03B 5/1852; H03B 5/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **28.06.2024   US 202418757809**

(71) Applicant: **Intel Corporation
Santa Clara, CA 95054 (US)**

(72) Inventors:
- **KUTTAPPA, Ragh**
  **Portland, 97209 (US)**
- **HONKOTE, Vinayak**
  **Hillsboro, 97124 (US)**
- **KAMALKAR, Gaurav**
  **560016 Bengaluru (IN)**
- **RAO, Amreesh**
  **Folsom (US)**
- **FINLEY, Eric**
  **Ione, 95640 (US)**
- **CHANDRASHEKAR, Kailash**
  **Portland, 97217 (US)**
- **SUNDARAM PRIYA, Jainaveen**
  **Hillsboro, 97123 (US)**
- **KARNIK, Tanay**
  **Portland, 97229 (US)**
- **MOREIN, Stephen**
  **San Jose, 95148 (US)**
- **KURIAN, Dileep**
  **Portland, 97229 (US)**
- **YADA, Satish**
  **Portland (US)**
- **RANGACHAR SRINIVASA, Srivatsa**
  **Hillsboro (US)**
- **MORROW, Patrick**
  **Portland, 97229 (US)**
- **FISCHER, Paul**
  **Portland, 97229 (US)**
- **QIAN, Zhiguo**
  **Chandler (US)**
- **ELSHERBINI, Adel A.**
  **Chandler, 85248 (US)**

(74) Representative: **Viering, Jentschura & Partner
mbB
Patent- und Rechtsanwälte
Am Brauhaus 8
01099 Dresden (DE)**

(54) **RESONANT CLOCKING ARCHITECTURE**

(57)    A rotary oscillator array (ROA) apparatus includes a plurality of rotary traveling wave oscillators (RTWOs) configured to generate a plurality of resonant clock signals. An RTWO of the plurality of RTWOs includes a plurality of inverter cells and a fractional divider. The inverter cells are coupled in parallel to each other between two metal interconnects. The fractional divider is coupled to the two metal interconnects. The fractional divider will output a resonant clock signal of the plurality of resonant clock signals based on a reset-out signal generated by a reset-out terminal of the RTWO.

**EP 4 671 911 A1**

**(Cont. next page)**

FIG. 1

**Description**

BACKGROUND

Graphics processing units (GPUs) have become a cornerstone of compute-intensive applications, which have resulted in the clock design complexity growing exponentially. However, challenges associated with clocking architectures spread across multi-die, multi-process, large synchronous domains, low latency designs, etc. Graphics products, as well as other compute architectures, can benefit from a robust low-power, low-skew, and low-jitter clocking solution that can be scaled across various product segments such as client computing, discrete graphics (DG), and high-performance Computing (HPC).

BRIEF DESCRIPTION OF THE DRAWINGS

In the drawings, like numerals may describe the same or similar components or features in different views. Like numerals having different letter suffixes may represent different instances of similar components. Some embodiments are illustrated by way of example, and not limitation, in the figures of the accompanying drawings listed below.

FIG. 1 is a block diagram of a resonant clocking implementation on a graphics core partition, in accordance with some embodiments.

FIG. 2A is a block diagram of a rotary traveling wave oscillator (RTWO), in accordance with some embodiments.

FIG. 2B is a block diagram of a rotary oscillator array (ROA), in accordance with some embodiments.

FIG. 3 is a block diagram of a resonant clocking architecture including four RTWOs with fractional dividers, a reset input, and reset outputs, in accordance with some embodiments.

FIG. 4A is a block diagram of a RTWO, in accordance with some embodiments.

FIG. 4B is a data and clock transfer synchronization structure embedded with a RTWO, in accordance with some embodiments.

FIG. 5A is a block diagram of a metal stack used in connection with disclosed embodiments.

FIG. 5B is a block diagram of RTWO connections using the back side metal layers, in accordance with some embodiments.

FIG. 6 is a block diagram of reset synchronization paths of a resonant clocking architecture, including four RTWOs, in accordance with some embodiments.

FIG. 7 is a graph of example reset synchronization outputs, in accordance with some embodiments.

FIG. 8 is a block diagram of a clocking architecture, in accordance with some embodiments.

FIG. 9 is a block diagram of a rectangular rotary traveling wave oscillator (RRTWO), in accordance with some embodiments.

FIG. 10 is a block diagram of a rectangular rotary oscillator array (RROA), in accordance with some embodiments.

FIG. 11 is a block diagram of a clock die-to-die (D2D) synchronization scheme for RTWOs, in accordance with some embodiments.

FIG. 12A is a block diagram of a RRTWO, in accordance with some embodiments.

FIG. 12B is a graph of clock signals generated by the RRTWO of FIG. 12A, in accordance with some embodiments.

FIG. 13 is a block diagram of an RROA with six RRTWO rings, in accordance with some embodiments.

FIG. 14 is a block diagram of a resonant clocking architecture for D2D input-outputs (IOs), in accordance with some embodiments.

FIG. 15 is a graph of clock signals generated by the resonant clocking architecture of FIG. 14, in accordance with some embodiments.

FIG. 16 is a block diagram of a clocking architecture with RTWOs, in accordance with some embodiments.

FIG. 17A is a block diagram of RTWO synchronization and deterministic clock phase points between two RTWO rings, in accordance with some embodiments.

FIG. 17B is a block diagram illustrating a locking scheme for the two RTWO rings of FIG. 16A with the two rings shorted at two points, in accordance with some embodiments.

FIG. 18 is a graph of RTWO synchronization with two rings separated by 0.35 mm, in accordance with some embodiments.

FIG. 19 is a graph of RTWO synchronization with two rings separated by 0.7 mm, in accordance with some embodiments.

FIG. 20 is a graph of RTWO synchronization with two rings separated by 0.7 mm, in accordance with some embodiments.

FIG. 21 is a block diagram of topology to connect multiple RTWO rings across different chiplets, in accordance with some embodiments.

FIG. 22 is a graph of the phase of 16 GHz RTWO, in accordance with some embodiments.

FIG. 23 is a diagram of resonant clock synchronization across a 3D stacked system, in accordance with some embodiments.

FIG. 24A is a diagram of a metal stack cross-section in a CMOS process, in accordance with some embodiments.

FIG. 24B is a diagram of RTWO connections, in accordance with some embodiments.

FIG. 25 is a diagram of a monolithic 3D stacked implementation, showing detailed connections between top metal layers across tiers, in accordance with some embodiments.

FIG. 26 is a diagram of a monolithic 3D stacked implementation with flipped tiers showing detailed connections between top metal layers across tiers, in accordance with some embodiments.

FIG. 27 is a graph of ROA synchronization and clock skew across three tiers, in accordance with some embodiments.

FIG. 28 illustrates a hybrid bonding-based IC solution, in accordance with some embodiments.

FIG. 29 is a diagram of a hybrid bonded interconnect (HBI) between face-to-face stacked 3D integration, in accordance with some embodiments.

FIG. 30 is a diagram of resonant clock synchronization across a 3D stacked system with HBI, in accordance with some embodiments.

FIG. 31A is a diagram of a metal stack cross-section in a CMOS process, in accordance with some embodiments.

FIG. 31B is a diagram of RTWO connections, in accordance with some embodiments.

FIG. 32 is a diagram of HBI connections for RTWO between two tiers, in accordance with some embodiments.

FIG. 33 is a graph of ROA synchronization and clock skew across two tiers, in accordance with some embodiments.

FIG. 34 is a flow diagram of an example method for generating synchronization signals, in accordance with some embodiments.

FIG. 35 illustrates a block diagram of an example machine upon which any one or more of the operations/techniques (e.g., methodologies) discussed herein may perform.

DETAILED DESCRIPTION

The following detailed description refers to the accompanying drawings. The same reference numbers may be used in different drawings to identify the same or similar elements. In the following description, for purposes of explanation and not limitation, specific details are set forth, such as particular structures, architectures, interfaces, techniques, etc., to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail.

The following description and the drawings sufficiently illustrate specific embodiments to enable those skilled in the art to practice them. Other embodiments may incorporate structural, logical, electrical, process, and other changes. Portions and features of some embodiments may be included in or substituted for those of other embodiments. Embodiments outlined in the claims encompass all available equivalents of those claims.

As used herein, the term "chip" (or die) refers to a piece of a material, such as a semiconductor material, that includes a circuit, such as an integrated circuit or a part of an integrated circuit. The term "memory IP" indicates memory intellectual property. The terms "memory IP," "memory device," "memory chip," and "memory" are interchangeable.

The term "a processor" configured to carry out specific operations includes both a single processor configured to carry out all of the operations (e.g., operations or methods disclosed herein) as well as multiple processors individually configured to carry out some or all of the operations (which may overlap) such that the combination of processors carry out all of the operations.

As used herein, the term "IO" indicates input/output. As used herein, the term "D2D" indicates a die-to-die connection. As used herein, the term "R-C" indicates resistance and capacitance. As used herein, the term "Rx" indicates receiver (or receive). As used herein, the term "Tx" indicates transmitter (or transmit). As used herein, the term "TRX" indicates transceiver. As used herein, the term "UCIe" indicates Universal Chiplet Interconnect Express. As used herein, the term "Vref" indicates reference voltage. As used herein, the term "Vin" indicates input voltage. As used herein, the terms "serially coupled," "serially connected," and "connected in series" are synonymous to each other and indicate a serial connection between two or more components/circuits where the serial connection can be based on a direct or indirect electrical connection between the two or more components/circuits. As used herein, the terms "parallel coupled," "parallel connected," and "connected in parallel" are synonymous to each other and indicate a parallel connection between two or more components/circuits where the parallel connection can be based on a direct or indirect electrical connection between the two or more components/circuits.

Resonant rotary clocking can generate and distribute robust, high-speed, low-skew, low-jitter, and low-power clocks across large dies. Rotary traveling wave oscillators (RTWOs) can be configured as rotary oscillatory arrays (ROAs) that provide a low-power scalable solution. In some aspects, an RTWO that is part of a ROA can provide deterministic same-phase clocks. To ensure the RTWO clocks are applicable to graphics products across various frequency requirements, an RTWO (also referred to as an RTWO ring) can be embedded with its fractional divider that provides various fractional granularities. In addition, to ensure the clocks are distributed across the design and the outputs of the fractional dividers are synchronous, a custom reset synchronizer can be used.

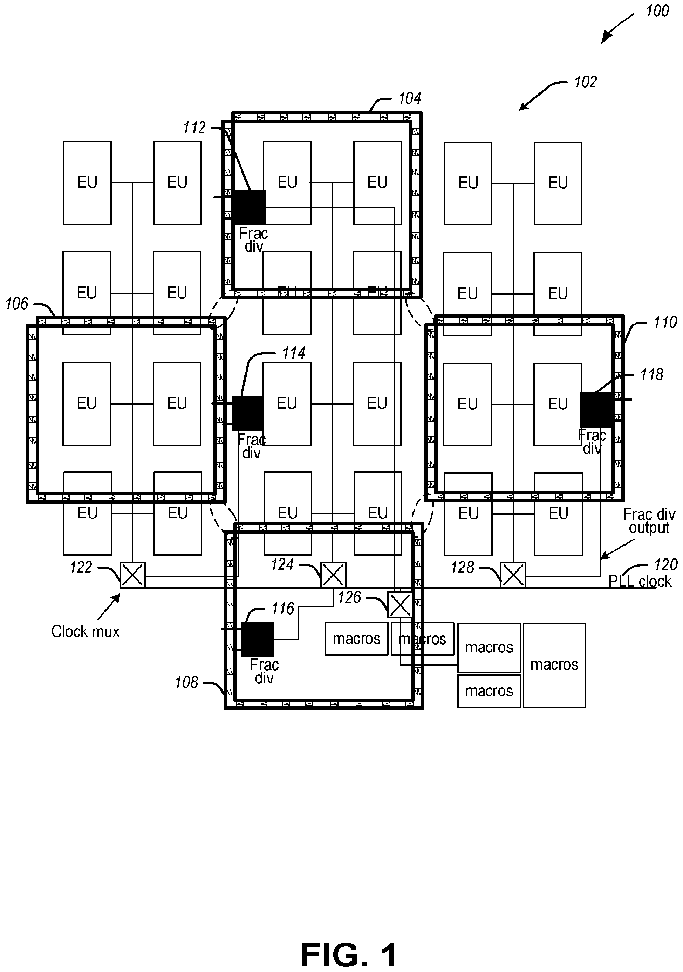

The disclosed techniques (e.g., as described in connection with FIG. 1 - FIG. 7) include resonant rotary clocking architectures, which can be integrated into large graphics dies. In some aspects, the disclosed techniques (e.g., as described in connection with FIG. 1 - FIG. 7) include the following configurations:

(a) A resonant rotary clocking architecture with robust same-phase aligned clocks across large dies and graphics designs;
(b) An implementation of RTWOs and ROAs using a backside metal process;
(c) A scheme to implement and integrate fractional dividers to enable dynamic frequency scaling across different voltage/frequency values with RTWOs for graphics products; and
(d) A scalable divider synchronization architecture for synchronous clocking of compute cores (e.g., graphics technology (GT) cores) across large dies.

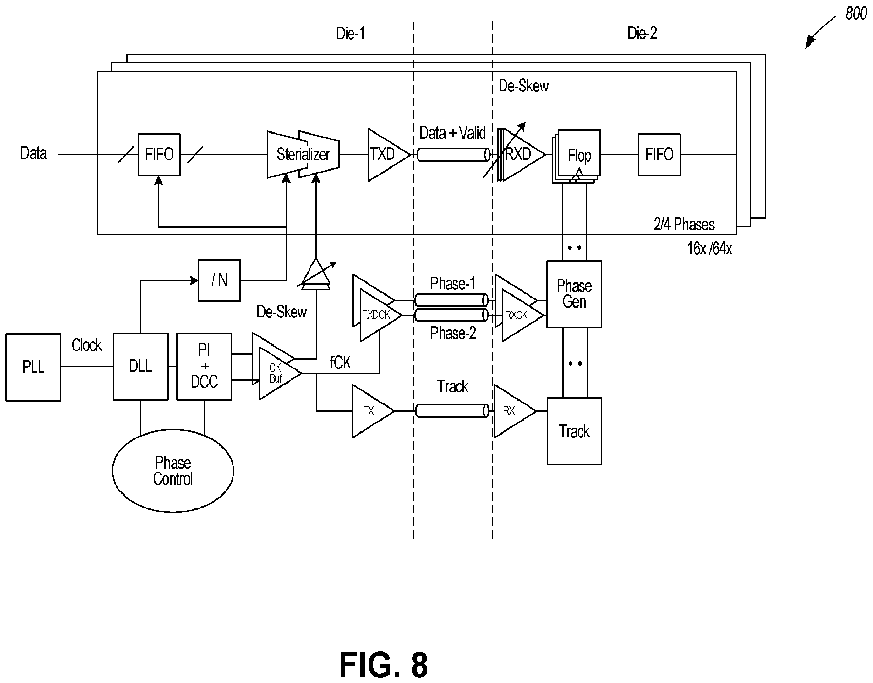

The disclosed techniques (e.g., as described in connection with FIG. 8 - FIG. 22) include the following configurations to provide multiphase clocks for universal chiplet interconnect express (UCIe) compliant/D2D topologies:

(a) A rectangular rotary traveling wave oscillator (RRTWO) that can be implemented on a chiplet or a base die, enabling UCIe-compliant D2D interfaces; and

(b) A rectangular rotary oscillator array (RROA) chiplet-to-chiplet synchronization architecture that provides multiple phase points across a large base die, demonstrating scalability.

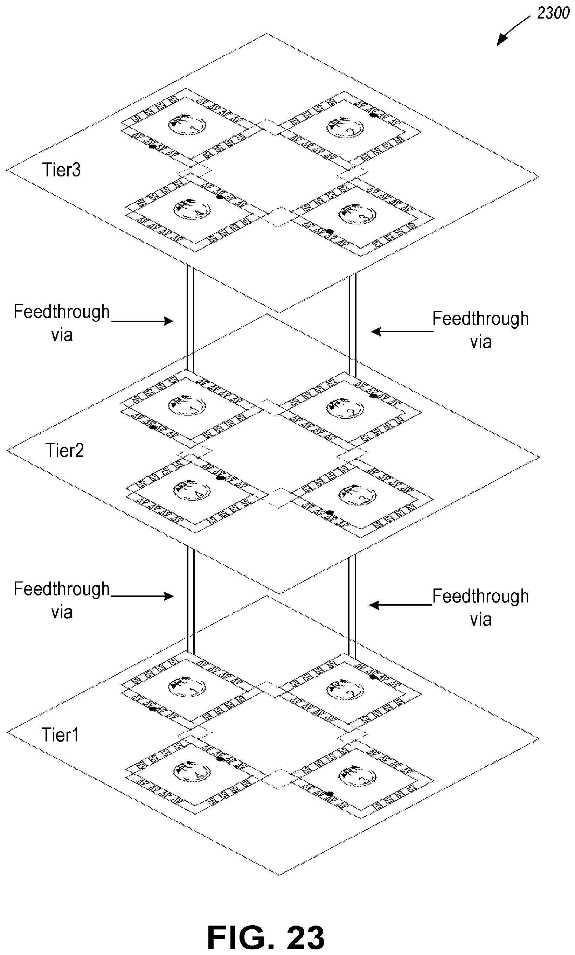

The disclosed techniques (e.g., as described in connection with FIG. 23 - FIG. 27) include a traveling wave-based resonant rotary clocking scheme for inter-tier synchronization in 3D stacked systems leveraging feedthrough vias without the additional overhead of de-skew circuits.

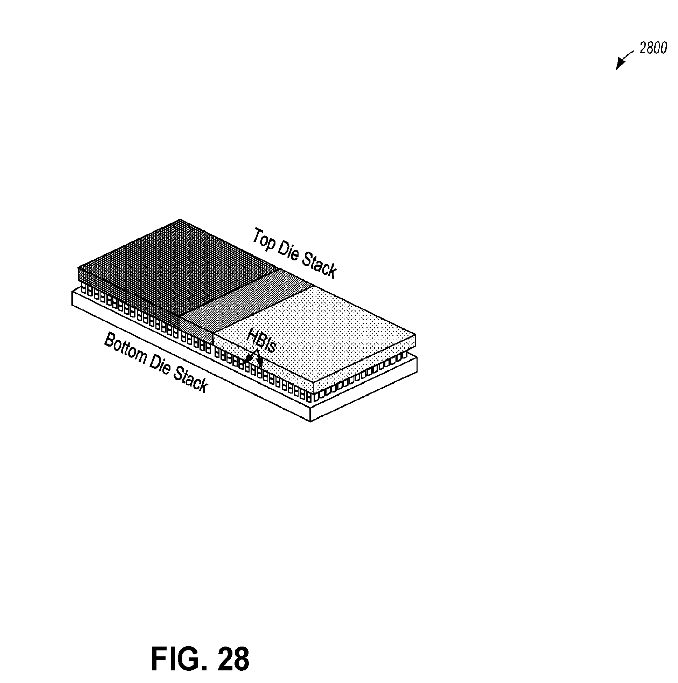

The disclosed techniques (e.g., as described in connection with FIG. 28 - FIG. 33) include a traveling wave-based resonant rotary clocking scheme for inter-tier synchronization in 3D stacked systems leveraging hybrid bonded interconnect (HBI) technology without the additional overhead of de-skew circuits.

FIG. 1 is a block diagram of a resonant clocking architecture 100 on a graphics core partition, in accordance with some embodiments. Referring to FIG. 1, the resonant clocking architecture 100 includes an ROA formed by RTWOs 104, 106, 108, and 110 (each RTWO can also be referred to as a resonant structure, a resonant ring, or a rotary ring).

In some aspects, the resonant clocking architecture 100 can be configured with a clock multiplexing scheme to provide flexibility in switching between resonant clocking and PLL-based clocking. More specifically, RTWOs 104, 106, 108, and 110 include corresponding fractional dividers 112, 114, 116, and 118, which can be configured to supply corresponding resonant clock signals generated by the RTWOs. The resonant clock signals generated by RTWOs 104, 106, 108, and 110 are supplied by fractional dividers 112, 114, 116, and 118 to the corresponding clock multiplexers 126, 122, 124, and 128.

In some aspects, the resonant clocking architecture 100 includes a PLL clock source 120 supplying a PLL (local) clock signal to clock multiplexers 122 - 128. Clock multiplexers 122 - 128 can select one of the local clock signals or the resonant clock signal to supply the execution units (EUs) 102.

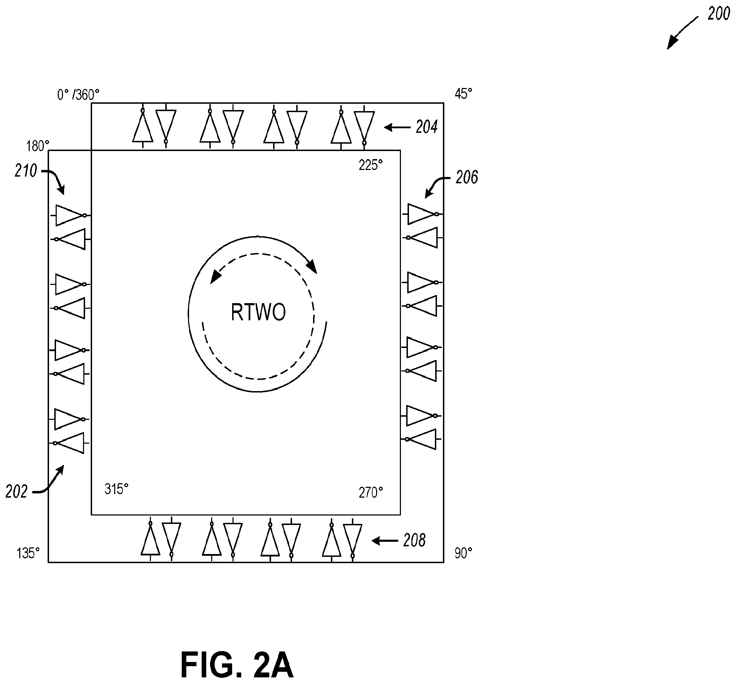

FIG. 2A is a block diagram of a rotary traveling wave oscillator (RTWO), in accordance with some embodiments. Referring to FIG. 2A, RTWO 200 can be configured with multiple sets of cross-coupled inverter pairs, such as inverter pair sets 202, 204, 206, and 208 coupled between metal interconnects 210.

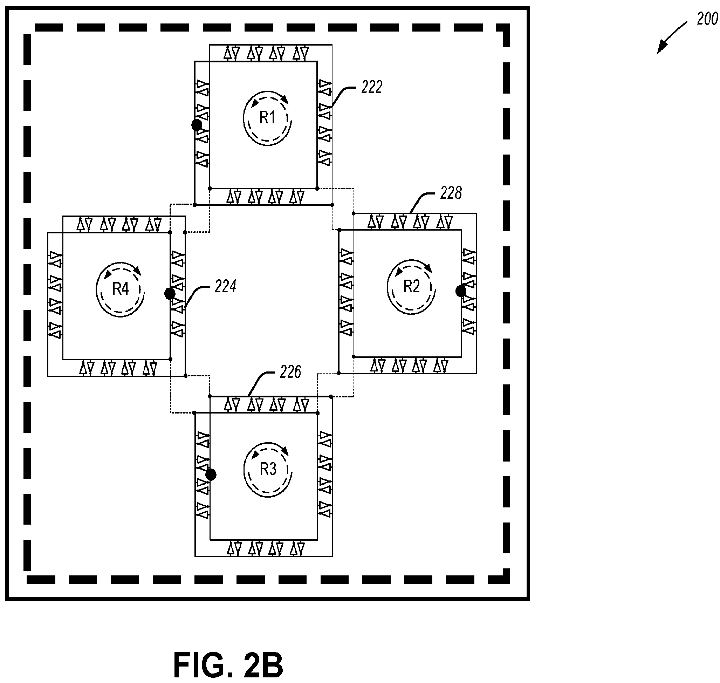

FIG. 2B is a block diagram of a rotary oscillator array (ROA), in accordance with some embodiments. Referring to FIG. 2B, ROA 220 is formed by a plurality of RTWOs 222, 224, 226, and 228 (which can be the same as RTWO 200).

In some aspects, the RTWO can be configured using IC interconnects for the transmission lines. CMOS inverters can be distributed uniformly along the transmission lines in an anti-parallel fashion to power and amplify the signals adiabatically. In some aspects, the RTWO can be modeled as an LC oscillator, where the frequency $f_{osc}$ is estimated by the following equation:

$$f_{osc} \approx \frac{v_p}{2l} = \frac{1}{\sqrt{L_T C_T}} \quad (1)$$

In equation (1), $v_p$ is the phase velocity and $l$ is the length/perimeter of the ring. The 2 factor (in the denominator) arises from the fact that the pulse requires two complete laps for a single cycle. Further, the total inductance and total capacitance of a rotary ring can be defined by $L_T$ and $C_T$, respectively. The total inductance $L_T$ depends on the geometry of the rotary ring. Parameter $C_T$ is the total capacitance of the ring, interconnects, and devices connected to the rotary ring.

In some aspects, the RTWO can be configured using the backside metal layers (e.g., to configure the metal interconnects 210). The proposed RTWO synchronization scheme is a scalable solution that can be placed along with the backside power grid with minimal area overhead while providing benefits in skew, duty cycle, period jitter, and power.

In some aspects, the disclosed RTWO is configured as a square RTWO where the length of the rotary ring is the same on all four sides.

In comparison to the disclosed resonant clock generation solutions, prior clock generation solutions are associated with the following drawbacks:

(a) The globally asynchronous locally synchronous (GALS) solution has multiple design overhead and verification challenges that have distanced designers from asynchronous solutions in general.

(b) From a multi-die-system (MDS) viewpoint, it can be challenging to synchronize the clocks across the reticle, and existing solutions are complex.

(c) As the need for speed in high-performance designs continues to increase (with smaller/better energy/bit requirements), prior art approaches employ a PLL to generate high-speed edges (to serialize data) and forward them. However, forwarded clock architectures require clock and data recovery circuits, phase interpolators, and skew correction circuits to ensure the clock frequency and phase characteristics are deterministic, which reduces overall efficiency.

In some aspects, the disclosed techniques include configuring RTWOs with on-chip interconnects and inverter pairs that are terminated mobiusly to generate a resonating clock signal with approximately a 50% duty cycle. In some aspects, the RTWO interconnects can be implemented using the backside metal layers.

In some aspects, the RTWOs are distributed across a system, such as the system shown in FIG. 1. Each RTWO has a fractional divider embedded within it to provide the required clock frequencies to the logic.

In some aspects, the resonant ring oscillates to generate the deterministic phase points across a system, which are used to provide the same phase points to the fractional divider. In some aspects, the fractional dividers within the RTWOs across the ROA are synchronized with a custom high-speed reset synchronizer to ensure all the fractional dividers come out of reset synchronously.

In some aspects, the disclosed techniques are associated with the following advantages over existing clock generation techniques:

(a) The overall implementation of resonant clocking structures on-die/interposer for synchronization across chiplet/reticle size has not been used by prior techniques. Chiplet-aware resonant clock implementation would aid in identifying the required clock tap-point synchronization.

(b) Due to the phase/frequency alignment properties of RTWOs, clock synchronization across a large die size is possible.

(c) As the traveling wave scheme provides deterministic delay, this can be used in clock synchronization with reduced skew and duty cycle degradation. The resultant skew and jitter values with the proposed scheme are low (in the order of fs). It can be difficult to achieve similar results with conventional schemes.

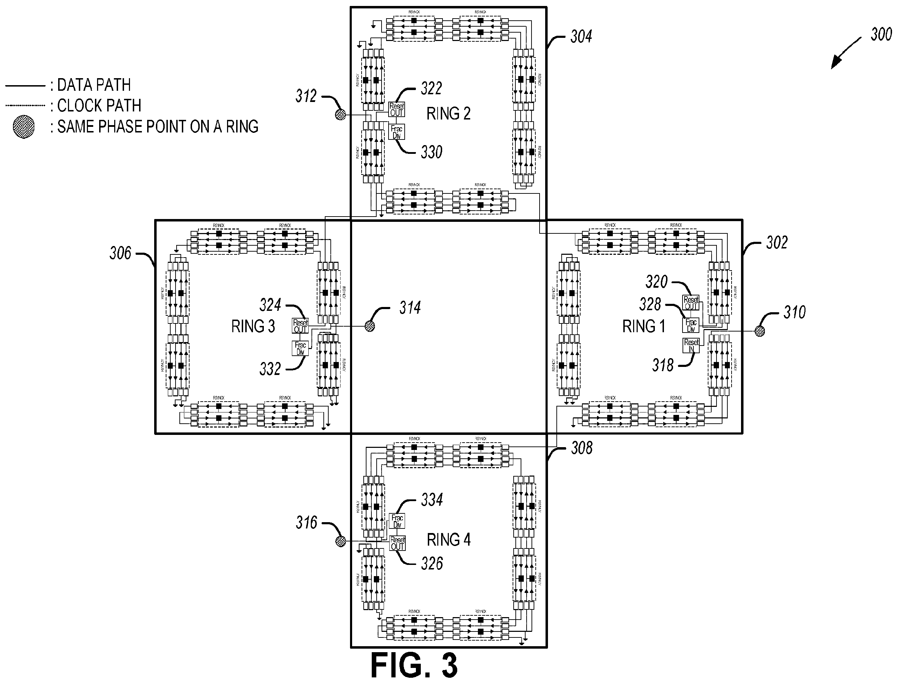

FIG. 3 is a block diagram of a resonant clocking architecture including four RTWOs with fractional dividers, a reset input, and reset outputs, in accordance with some embodiments. Referring to FIG. 3, the resonant clocking architecture 300 can include RTWOs 302, 304, 306, and 308 as well as additional components (as illustrated in FIG. 3) to configure the data path (e.g., to communicate the reset signal) and clock path (to communicate/output the resonant clock signals generated by the RTWOs). More specifically, the resonant clocking architecture 300 includes reset synchronization circuitry, including a reset-in port 318 (only one reset-in port can be used), reset-out ports 320, 322, 324, and 326, and fractional dividers 328, 330, 332, and 334.

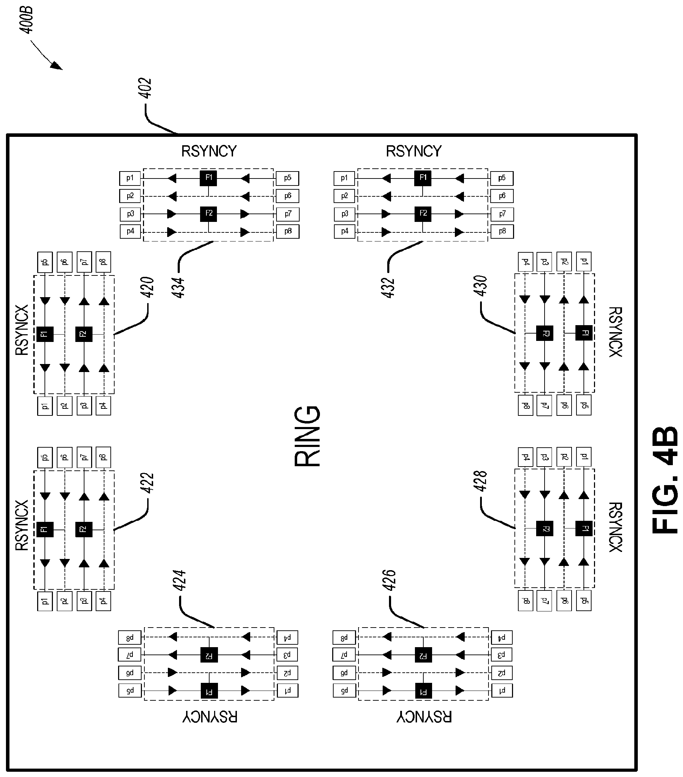

In operation, the reset-in signal is received at the reset-in port 318. This causes a reset signal to be communicated via the corresponding data paths to the corresponding reset-out ports. The corresponding data paths can include one or more flip-flops and one or more inverters (e.g., as illustrated in FIG. 4B), and the data paths can be configured with the same signal delay so that all data paths are synchronized with each other so that the resonant clock is output by the fractional dividers synchronously.

The reset signal is received at the reset-out ports, which causes a reset-out signal to be generated and communicated to the fractional dividers. The fractional dividers then output the resonant clock signals generated by the corresponding RTWOs. In some aspects, the resonant clock signals can be output at the corresponding phase points 310, 312, 314, and 316.

In some aspects, each RTWO ring edge has a high-frequency bidirectional flip-flop structure that can transmit clocks and data across the entire ROA. In the resonant clocking architecture, it can be used to carry the reset across the different RTWO rings.

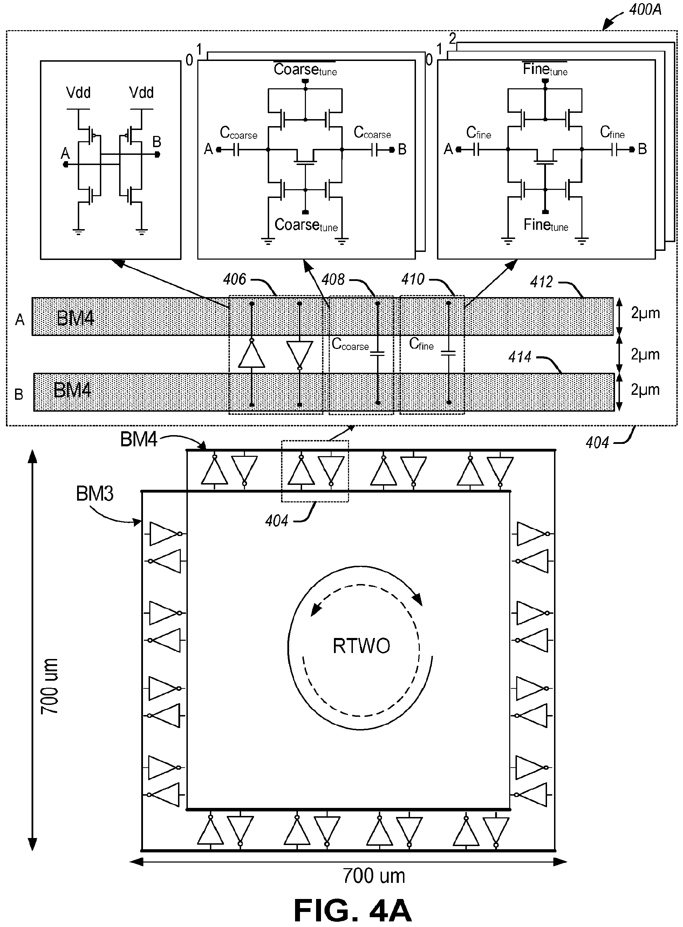

FIG. 4A is a block diagram 400A of a RTWO, in accordance with some embodiments. Referring to FIG. 4A, RTWO 402 can include a plurality of cross-coupled inverter circuits (such as inverter circuit 404). In some aspects, the inverter circuit 404 includes an inverter pair 406, a coarse-tuning capacitor 408, and a fine-tuning capacitor 410 coupled between metal layers 412 and 414. In some aspects, metal layers 412 and 414 are the backside metal (BM) layers of a substrate.

FIG. 4B is a data and clock transfer synchronization structure 400B embedded with an RTWO, in accordance with some embodiments. Referring to FIG. 4B, the data and clock transfer synchronization structure 400B can be configured with an RTWO 402 and can include a plurality of reset synchronization blocks 420, 422, 424, 426, 428, 430, 432, and 434. As illustrated in FIG. 4B, each of the reset synchronization blocks includes at least two flip-flop circuits and a plurality of buffers.

To ensure all the fractional dividers are providing the same phase clocks to the logic, a delay-matched reset synchronization technique can be used at the RTWO at high frequencies. In FIG. 4B, each edge of the RTWO consists of #n high-frequency flip-flop circuits that can be selected based on the clock frequency and ring edge length. The reset signal is propagated across all the rings in the RTWO, keeping the number of flip-flop circuits and distance from the reset-in port location and the reset-out port location identical. To control the delays, a number of flip-flop and buffer stages unit cells can be implemented. Each unit cell consists of bidirectional reset and clock carry paths. In some aspects, frontside metal layers can be used to route these paths and the resonant synchronization blocks. The unused reset and clock carry paths are tied off to ensure no switching activity takes place to save power.

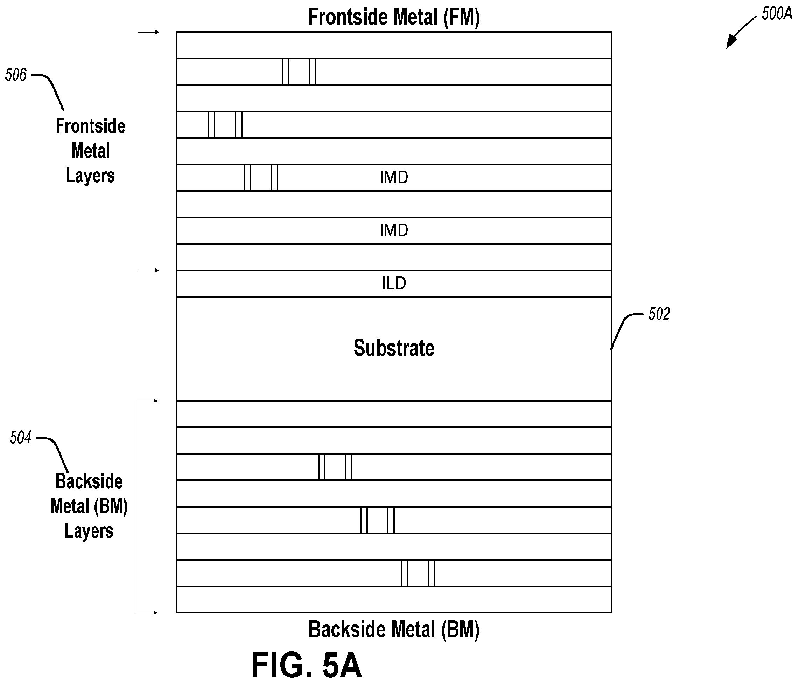

FIG. 5A is a block diagram of a metal stack 500A used in connection with disclosed embodiments. Referring to FIG. 5A, the metal stack 500A includes a substrate 502, frontside metal (FM) layers 506, and backside metal (BM) layers 504.

In FIG. 5A, the RTWO interconnects with identical parasitics in the backside layers, which can be used to implement the resonant clock structure.

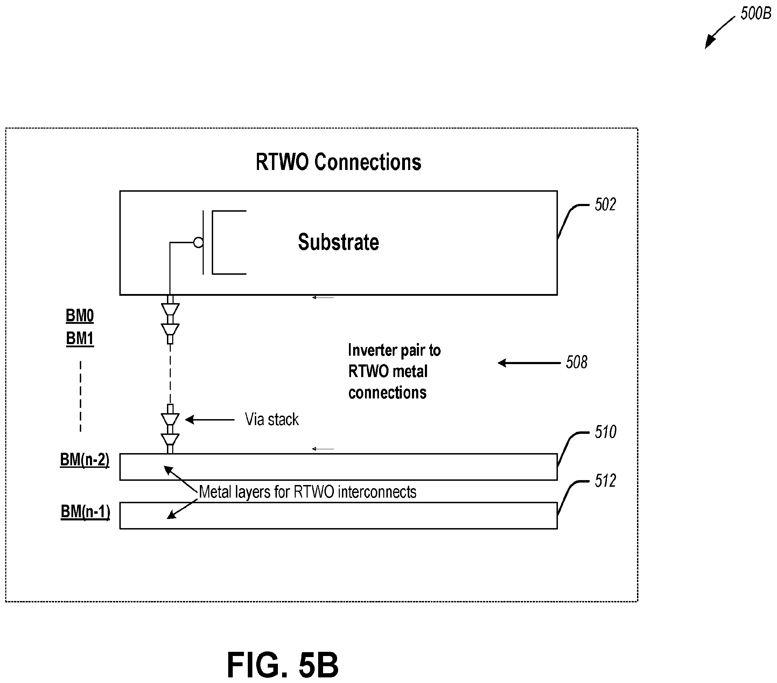

FIG. 5B is a block diagram 500B of RTWO connections using the back side metal layers, in accordance with some embodiments. Referring to FIG. 5B, an RTWO can be configured using the substrate 502 and metal layers 510 and 512, which can be part of the BM layers 504. The metal layers 510 and 512 can be connected to substrate 502 using a via stack 508.

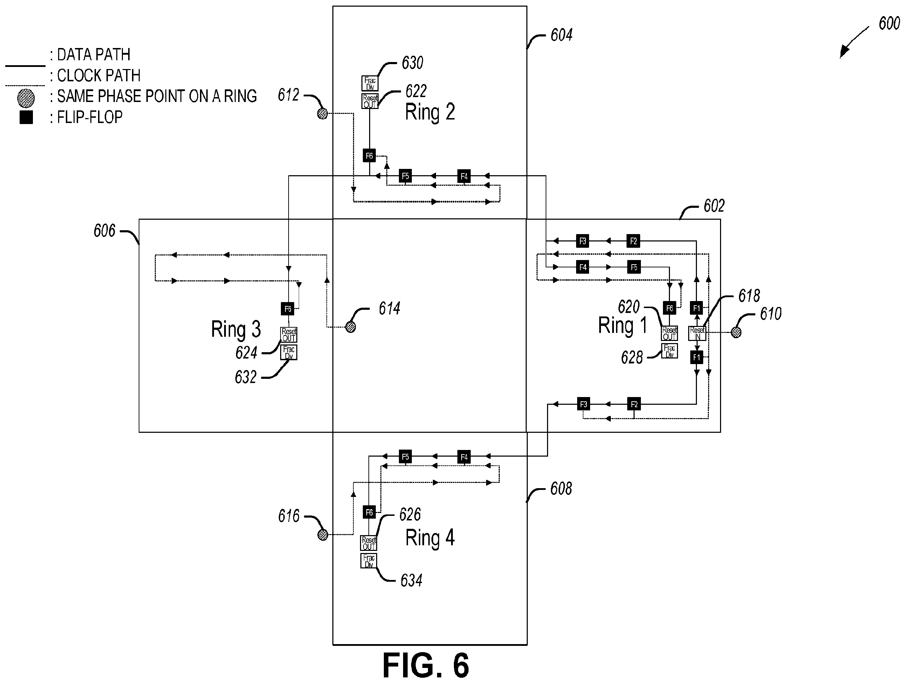

FIG. 6 is a block diagram of reset synchronization paths of a resonant clocking architecture 600, including four RTWOs, in accordance with some embodiments. Referring to FIG. 6, the resonant clocking architecture 600 can include RTWOs 602, 604, 606, and 608 as well as additional components (as illustrated in FIG. 6) to configure the data path (e.g., to communicate the reset signal) and clock path (to communicate/output the resonant clock signals generated by the RTWOs). More specifically, the resonant clocking architecture 600 includes reset synchronization circuitry, including a reset-in port 618 (only one reset-in port can be used), reset-out ports 620, 622, 624, and 626, and fractional dividers 628, 630, 632, and 634.

In operation, the reset-in signal is received at the reset-in port 618. This causes a reset signal to be communicated via the corresponding data paths to the corresponding reset-out ports. The corresponding data paths can include one or more flip-flops and one or more inverters (e.g., as illustrated in FIG. 6), and the data paths can be configured with the same signal delay so that all data paths are synchronized with each other so that the resonant clock is output by the fractional dividers synchronously.

The reset signal is received at the reset-out ports, which causes a reset-out signal to be generated and communicated to the fractional dividers. The fractional dividers then output the resonant clock signals generated by the corresponding RTWOs. In some aspects, the resonant clock signals can be output at the corresponding phase points 610, 612, 614, and 616.

In some aspects, the reset-in signal is fed into the reset-in port 618 at RTWO 602 at the same phase clock point. The number of stages the signal traverses through is chosen based on the farthest distance the reset signal must traverse. For the 4-ring ROA in FIG. 6, the number of flip-flop stages required is 6 to ensure the farthest RTWO (which is RTWO 606) has the synchronized reset-out signal at the same time interval as RTWOs 602, 604, and 608. Similarly, if the number of RTWOs scales, the high-frequency synchronizers can be implemented to ensure all the fractional dividers come out of reset at the same time interval.

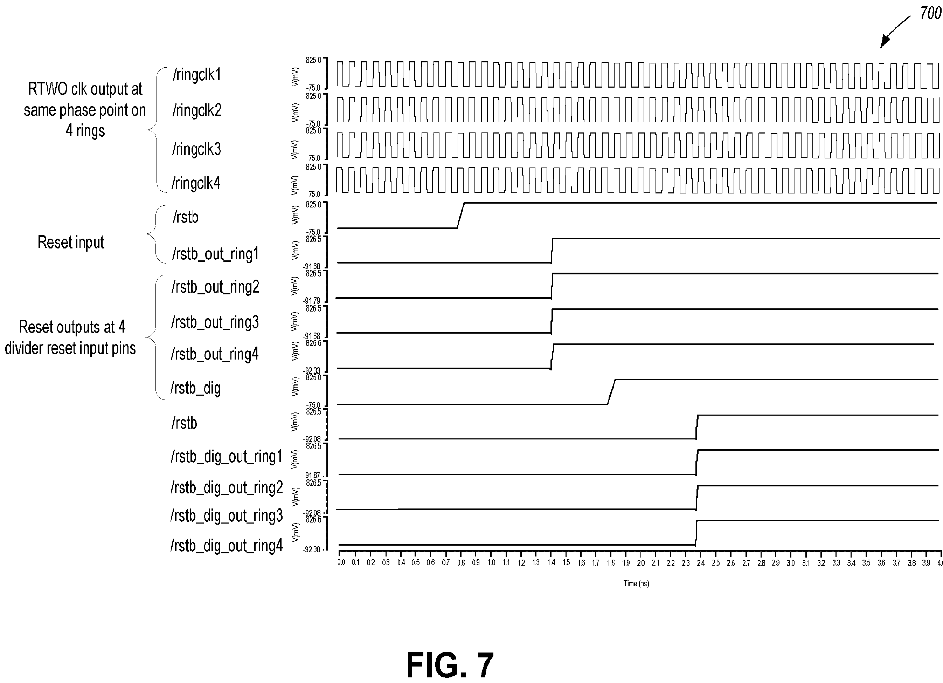

FIG. 7 is graph 700 of example reset synchronization outputs, in accordance with some embodiments. More specifically, graph 700 is a simulation snippet of the reset synchronizer on a graphic core partition implementation. The top four signals are the clock outputs of the respective RTWO rings. The fifth signal is the reset-in signal, and the following four signals are the reset signals at the outputs at the four-phase point in different locations.

In some aspects, heterogeneous architectures are designed with clock/data forwarding or asynchronous clocks that use additional circuits and clock domain crossing considerations. The Ground Referenced Signaling (GRS) solution, for instance, uses high-speed interconnects between dies for clock forwarding from on-chip phase locked loops (PLLs). Universal Chiplet Interconnect Express (UCIe) is an open, multi-protocol capable, on-package interconnect standard for connecting multiple dies on the same package. UCIe can support multiple protocols, such as PCIe and CXL, on top of a standard physical and link layer. The energy efficiency target for UCIe ranges from 0.5 pJ/bit to 1.25 pJ/bit based on the channel length (short/long).

FIG. 8 is a block diagram of a clocking architecture 800, in accordance with some embodiments. More specifically, clocking architecture 800 can be configured as forwarded clocking architecture with a two-phase forwarded clock for UCIe.

Typically, clock forwarding architectures transmit two different clock phases from the transmitter (Tx) to the receiver (Rx) end and utilize a clock phase generator and de-skew circuits to generate multiple clock phases and match skew across Tx/Rx blocks in interface circuits. For UCIe-compliant architectures, the phase difference between the two clock phases at different frequencies is listed in Table 1 below. For UCIe, a deterministic relationship between Tx/Rx clock phase points can be used, as listed in Table 1.

Clocking circuits are known to consume approximately ~10%-20% of the power in a traditional die-to-die (D2D) interface architecture. Specifically, graphics products can use a robust low-power, low-skew, and low-jitter clocking solution that can be scaled across various product segments, such as client computing, discrete graphics (DG), and high-performance computing (HPC). Current graphics architectures are targeting D2D link clock speeds up to 4.8 GHz, which means that the clock skew/jitter and power need to be minimal. Further, enabling UCIe for graphics by generating a low-power, high-frequency, and multiphase clock with a significant reduction in additional circuit infrastructure and power is highly important. The disclosed techniques can include a rotary traveling wave oscillator-based synchronous clocking for UCIe-compliant topologies.

TABLE 1 (Forwarded clock frequency and phase requirements)

| Data rate (GT/s) | Clock freq. (fCK) (GHz) | Phase -1 | Phase-2 | De-skew (Req/Opt) |
|---|---|---|---|---|
| 32 | 16 | 90 | 270 | Required |
| | 8 | 45 | 135 | Required |
| 24 | 12 | 90 | 270 | Required |
| | 6 | 45 | 135 | Required |
| 16 | 8 | 90 | 270 | Required |
| 12 | 6 | 90 | 270 | Required |
| 8 | 4 | 90 | 270 | Optional |
| 4 | 2 | 90 | 270 | Optional |

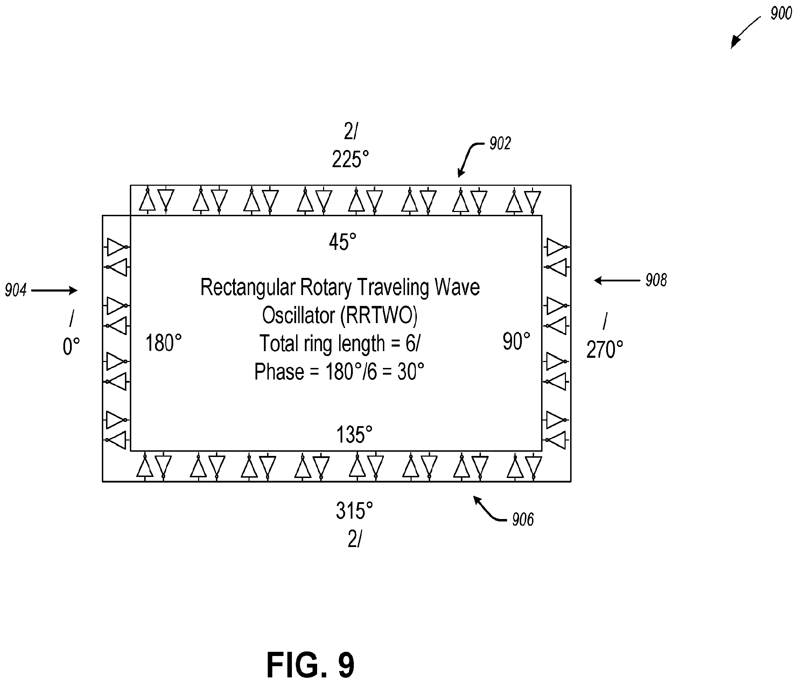

FIG. 9 is a block diagram of a rectangular rotary traveling wave oscillator (RRTWO) 900, in accordance with some embodiments. Referring to FIG. 9, RRTWO 900 can include cross-coupled inverter pair sets 902, 904, 906, and 908 along its sides. As illustrated in FIG. 9, clock signals of different phases can be tapped at different points along the four sides of the RRTWO 900 (e.g., as needed for specific circuit clocking configurations).

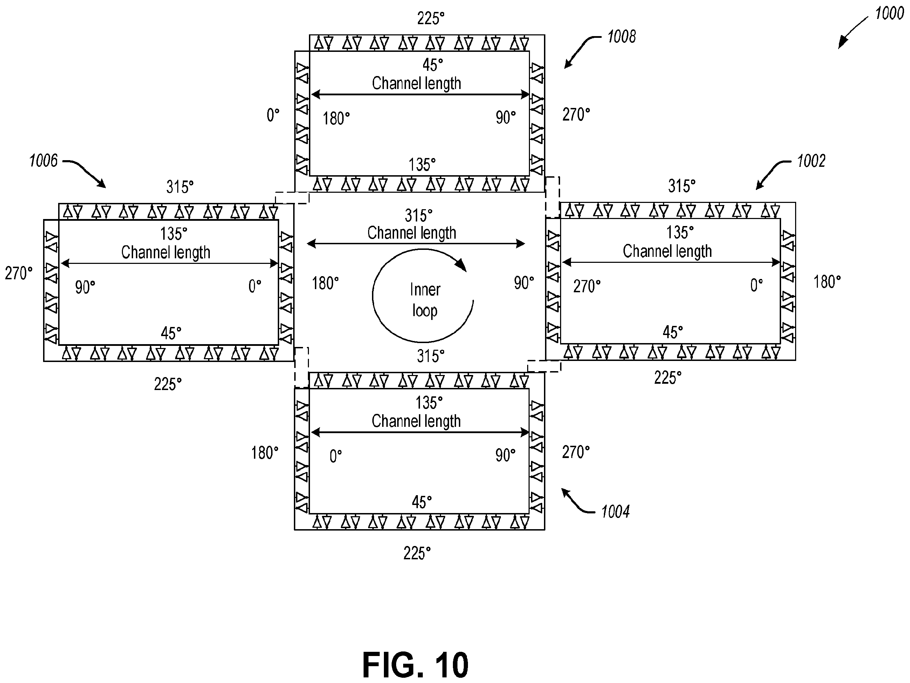

FIG. 10 is a block diagram of a rectangular rotary oscillator array (RROA), in accordance with some embodiments. Referring to FIG. 10, RROA 1000 includes a plurality of RRTWOs, such as RRTWOs 1002, 1004, 1006, and 1008. In some aspects, the size of each RRTWO, the number of RRTWOs, and the arrangement of the RRTWOs in the RROA can be selected based on resonant clock needs such as channel length for the clock signal delivery and resonant clock signal phase needed for output.

The disclosed techniques can include using RTWOs with on-chip interconnects and inverter pairs that are terminated mobiusly to generate a resonating clock signal with a 50% duty cycle. The disclosed techniques include a rectangular RTWO with deterministic phase points for D2D clocking and a chiplet-to-chiplet synchronization scheme for D2D clocking. The key innovations are as follows:

In some aspects, the RRTWOs/rectangular rotary oscillatory arrays (RROAs) can be scaled for tapping clocks for D2D IOs in a D2D architecture (as shown in FIG. 10).

In some aspects, rectangular resonant rings are implemented on a silicon interposer. The RRTWOs can be placed with the active inverter pairs either on the base die or top die to generate the resonant clock.

In some aspects, using RTWOs for chiplet-to-chiplet synchronization includes the following two configurations:

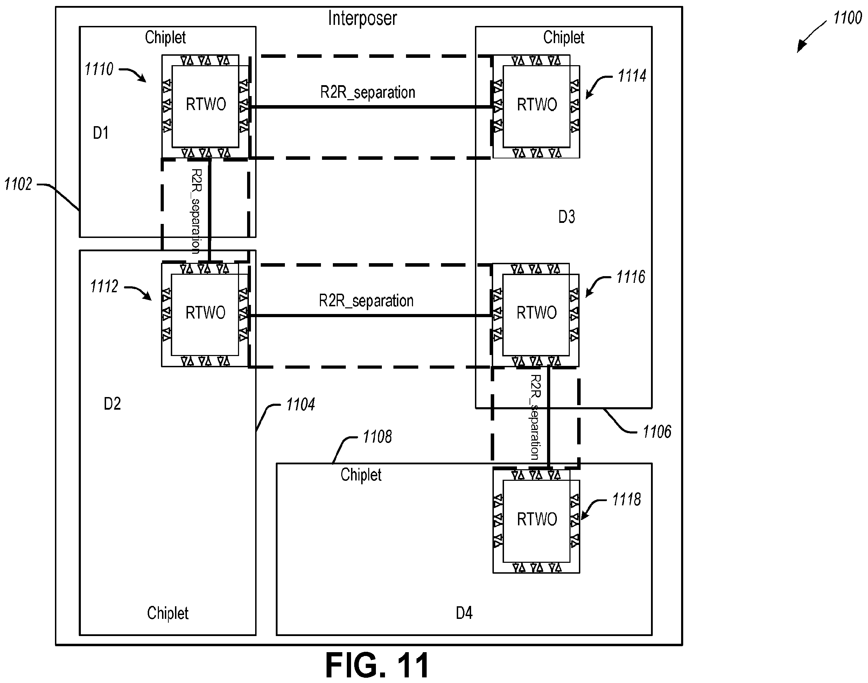

(a) The RTWOs can be distributed across a multi-die system, as shown in FIG. 11. The distributed RTWOs can be synchronized with high-speed interconnects routed across the interposer (R2R_separation).

(b) The synchronization between RTWOs can be controlled selectively between different chiplets.

In some aspects, the RTWOs can be placed either on the base die or top die to generate the resonant clock. In some aspects, RTWOs can be scaled to rotary oscillator arrays.

In some aspects, the resonant ring oscillates to generate the IO clock with deterministic phase points across the base die/chiplet die, which is used to serialize and de-serialize data.

In some aspects, the disclosed techniques can include schemes for synchronization across multiple dies both across the whole reticle (lateral - 2D) and with a base die and chiplet (vertical - 3D).

The disclosed overall implementation of resonant clocking structures on an interposer for synchronization across chiplet/reticle size is not used in existing architectures. Additionally, chiplet-aware resonant clock implementation would aid in identifying the required clock tap-points for D2D IOs.

FIG. 11 is a block diagram of a clock die-to-die (D2D) synchronization scheme for RTWOs, in accordance with some embodiments. Referring to FIG. 11, an interposer circuit 1100 includes chiplets 1102, 1104, 1106, and 1108. The chiplets can be used to collectively implement a ROA formed by RTWOs 1110, 1112, 1114, 1116, and 1118. The dashed lines in FIG. 11 indicate synchronization pathways.

Due to the phase/frequency alignment properties of resonant rotary clocking, clock synchronization can be achieved across a large die size using scalable RROAs. The disclosed rectangular rings (or RRTWOs) can be configured such that the 0 and 90 deg phase points are ~1mm apart based on the channel length for the IO circuits across two different chiplets.

In some aspects, the traveling wave scheme provides deterministic delay, which can be used in D2D IOs. This scheme has the advantage of using either the same phase points on multiple custom rings or different phase points with deterministic delays on the custom rings for D2D IOs. The resultant skew and jitter values with the proposed scheme are low (in the order of fs). It can be challenging to achieve similar results with conventional schemes.

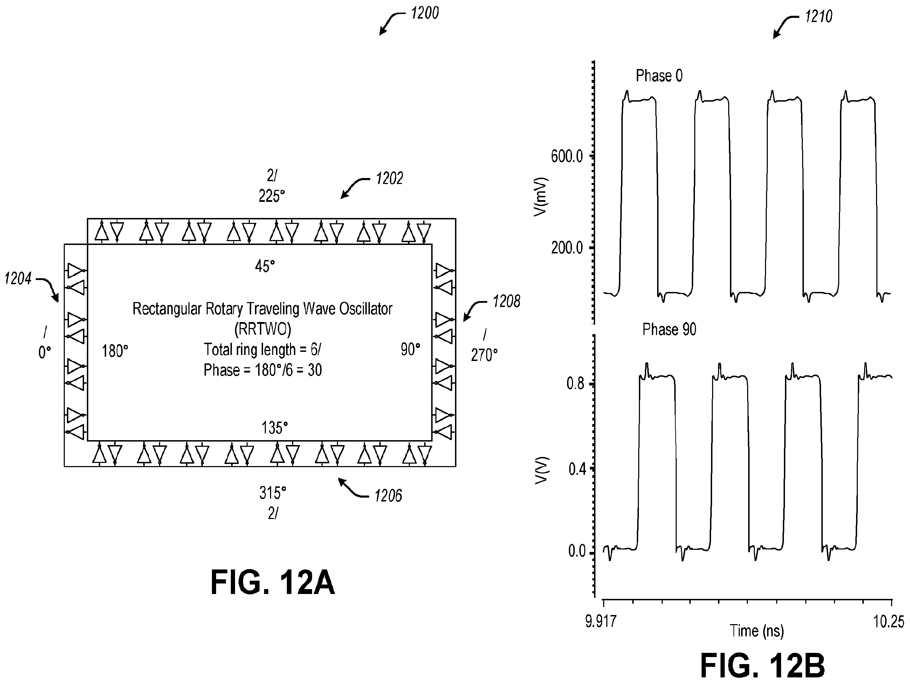

FIG. 12A is a block diagram of a RRTWO, in accordance with some embodiments. Referring to FIG. 12A, RRTWO 1200 includes inverter sets 1202, 1204, 1206, and 1208 arranged (connected) as illustrated in FIG. 12A.

FIG. 12B is a graph 1210 of clock signals generated by the RRTWO of FIG. 12A, in accordance with some embodiments.

In some aspects, rectangular rotary traveling wave oscillators are used for D2D communication. With the rotary traveling wave scheme, it is possible to tap the clock signals from different points of the rotary ring and provide them as inputs to the die-to-die IOs. As the delay/phase at the tapping points is deterministic, the difference in the phase/delay is used as the transmission window. In FIG. 12A, a representative scheme of a single traveling wave rectangular rotary traveling wave oscillator (RRTWO) (implemented with interposer) and different clock phases are illustrated. In heterogeneous systems, the length of the channel between two die-to-die IOs can be 1mm. The RRTWO is implemented such that the 0 and 90-degree phase points are 1mm apart (2 *l* in FIG. 9, with *l* being the length of the short side) as per UCIE requirements. In addition, routing the same phase points internal to the IO blocks across the shorelines is straightforward as the routing distances are small in the current implementations.

In FIG. 12B, the simulated waveforms of the clock signals of a single RRTWO with the 0 deg and 90 deg phase points that are 1mm apart are shown. RRTWOs have the advantage of not requiring square RTWOs, limiting the size of the ring to generate the required phase points across the two different chiplets.

In some aspects, scaling RRTWOs across the base die allows for using different RRTWO rings as the clock sources for the required clock phases across a large base die. In order to design a rectangular rotary oscillator array (RROA), the following design considerations may be used:

(a) The length of the inner loop can match the length of the RRTWO ring (shown in FIG. 12A and FIG. 9); and
(b) An RRTWO placed in the array can create an inner loop the size of the RRTWO ring (shown in FIG. 12A).

In FIG. 10, four RRTWO rings that form an RROA are illustrated. The total length of each ring is 6l, and the length of the inner loop is 6l (where *l* is the length of the short side of the RRTWO). The phase points for the ring are illustrated to show the different phase points on the ring. The phase points are deterministic and remain the same since the RRTWOs lock in phase and frequency.

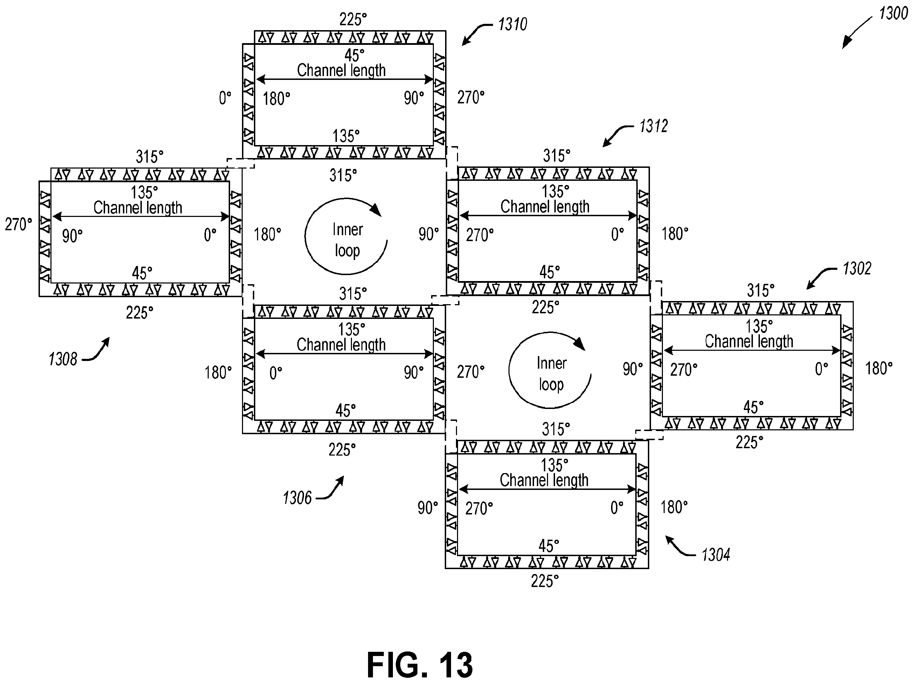

FIG. 13 is a block diagram of an RROA with six RRTWO rings, in accordance with some embodiments. Referring to FIG. 13, RROA 1300 includes RRTWOs 1302, 1304, 1306, 1308, 1310, and 1312. In this regard, two additional rings are added to the 4-ring RROA to form inner loops of the same length as the RRTWO.

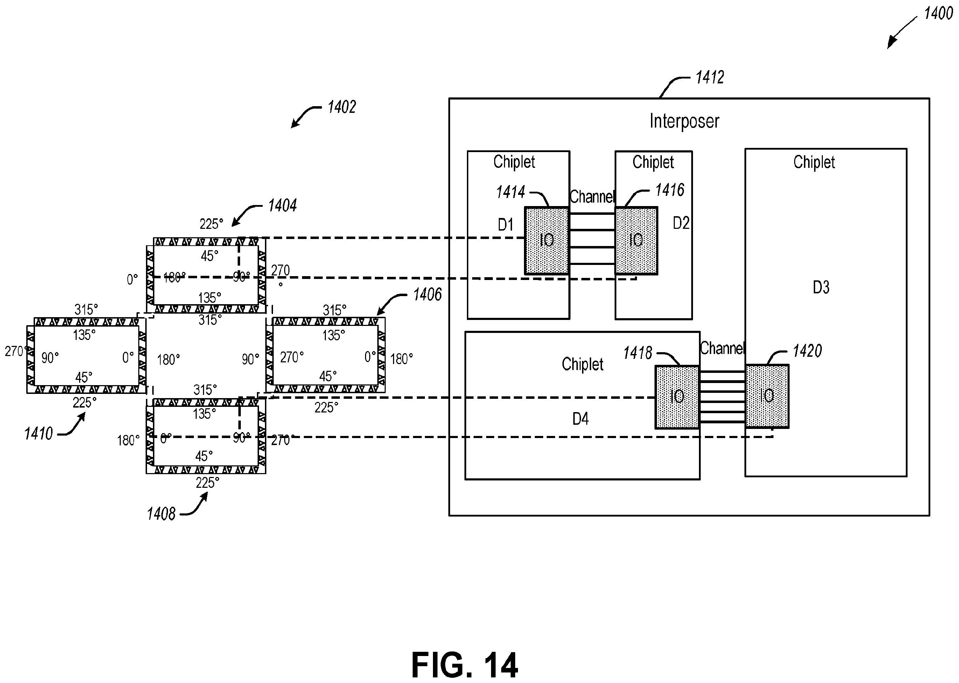

FIG. 14 is a block diagram of a resonant clocking architecture 1400 for D2D input-outputs (IOs), in accordance with some embodiments. Referring to FIG. 14, the resonant clocking architecture 1400 includes an interposer circuit 1412 coupled to RROA 1402. The RROA 1402 includes RRTWOs 1404, 1406, 1408, and 1410 which can supply resonant clock signals to Ios 1414, 1416, 1418, and 1420 on chiplets of the interposer circuit 1412.

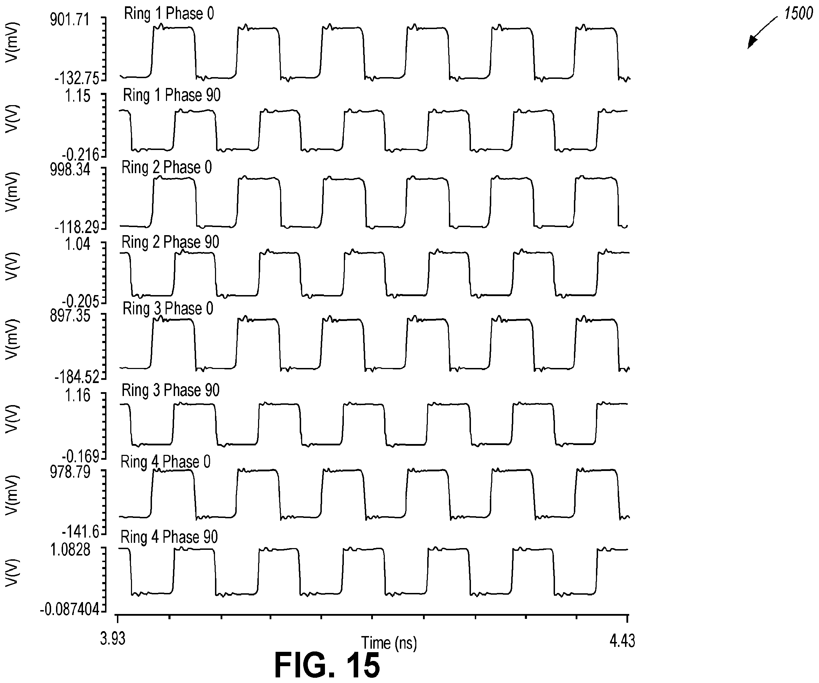

FIG. 15 is a graph 1500 of clock signals generated by the resonant clocking architecture of FIG. 14, in accordance with some embodiments.

In FIG. 14, the RRTWOs are arranged in an array (with 4 such rings) on the interposer. For UCIe-compliant die-to-die interfaces, the data is required to be transmitted at the 0-degree phase and received at the 90-degree phase (90 degrees apart). In this configuration, a channel length of 1mm can be selected, and the RRTWOs are implemented such that the 0-degree and 90-degree phase points are 1mm apart on an RRTWO. Further, depending on the architecture and placement of the dies, the resonant rings can be laid out to enable a favorable transmit/receive window for D2D IOs. In this regard, a chiplet-placement-aware resonant rotary clocking scheme can be implemented on the interposer for efficient D2D IOs. In addition, different phase points from different RRTWOs across the RROA can be chosen based on the required clock phases and channel lengths.

In FIG. 15, the 0-degree and 90-degree phase points across the 4-ring RROA are illustrated. To ensure the proposed clocking scheme is applicable to a range of frequencies for UCIe, frequency dividers can be placed at the clock source for frequency division, considering the maximum frequency of the resonant clock sources.

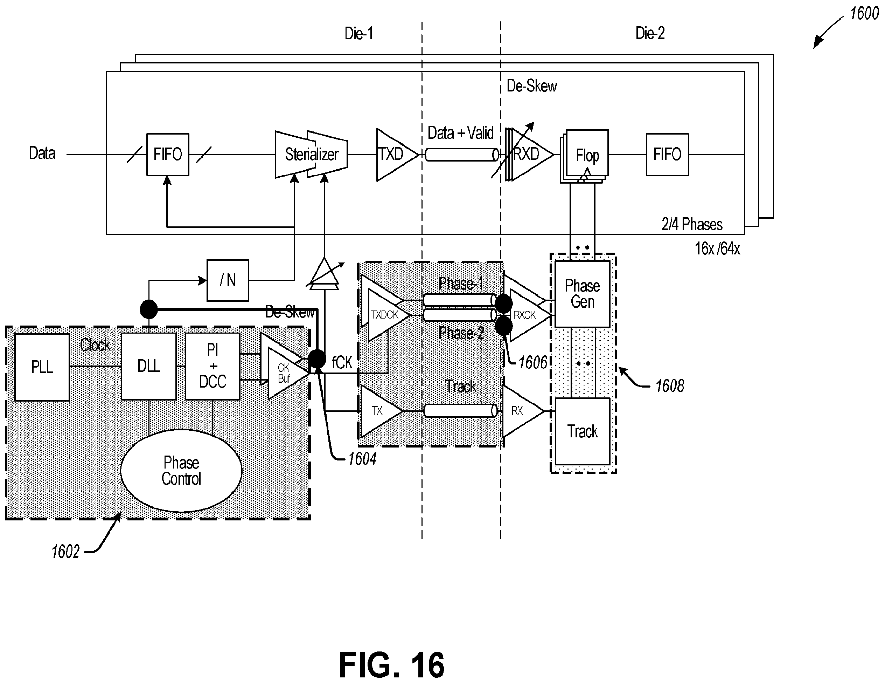

Compared to a traditional UCIe D2D IO, the proposed techniques can include replacing the clock generation and forwarding aspects. The proposed scheme can retain everything else from the PHY, including the on-die clock distribution, Clock-Domain-Crossing FIFOs, and methods to meet D2D timing. To elaborate, FIG. 16 illustrates a detailed representation of modifications to a typical UCIe PHY combined with the proposed scheme.

FIG. 16 is a block diagram of a clocking architecture 1600 with RTWOs, in accordance with some embodiments. In FIG. 16, blocks 1602 can be removed, blocks 1604 and 1606 are added, blocks 1608 offer potential for simplification, and the rest of the IO is kept the same.

In FIG. 16, the shaded blocks can be removed when using the proposed techniques. For example, both generation and forwarding of high-speed clocks can be removed. Instead of PLL generating high-frequency (HF) clocks, a resonant ring structure can be used to distribute deterministic phase clock points across both dies (at a reduced power footprint).

In some aspects, the components in block 1608 can optionally be simplified. Since resonant clocks are shown to be deterministic in phase and robust against variations, simple delay lines can be used at the Rx for deserialization.

At the Tx side (left portion of FIG. 16), instead of connecting the data slices to the PLL-generated clock, the data slices are tied to the 0-degree clock generated by the resonant ring (shown by the black dots at blocks 1604 and 1606). This allows the preservation of the existing clock matching, dividers, and on-die distribution present in the UCIe PHY. Through the proposed approach of modifying just the source of the clock going into this distribution network, there are minimal changes to the already existing clock distribution of 10+ GHz in the data slices.

At the Rx side, since the resonant rings provide robust high-speed clocks of deterministic phases (90-degree at the Rx side), the phase-gen and tracking parts can be simplified. Similar to the Tx side, the Rx received clock pin is connected to the 90-degree point of the Die-2 resonant ring.

The PHY's data slices, including clock routing at the Tx/Rx side, line delay matching to meet timing across dies, and FIFOs for clock crossing, are retained as is.

The following configurations can be used to synchronize RTWOs in a multi-die system.

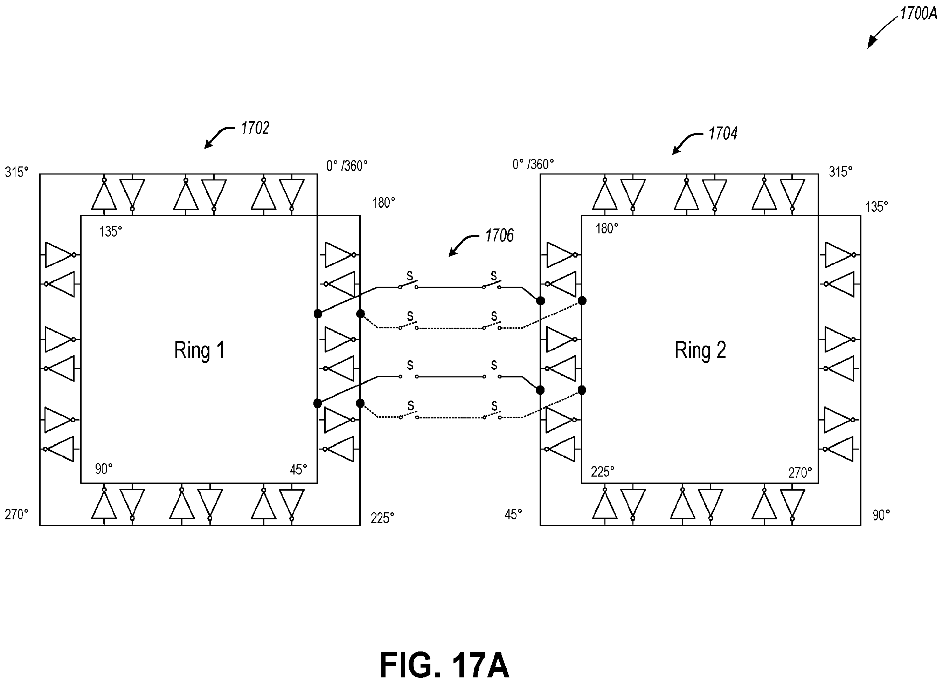

FIG. 17A is a block diagram 1700A of RTWO synchronization and deterministic clock phase points between two RTWO rings, in accordance with some embodiments. Referring to FIG. 17A, RTWOs 1702 and 1704 can be coupled via high-speed interconnects 1706.

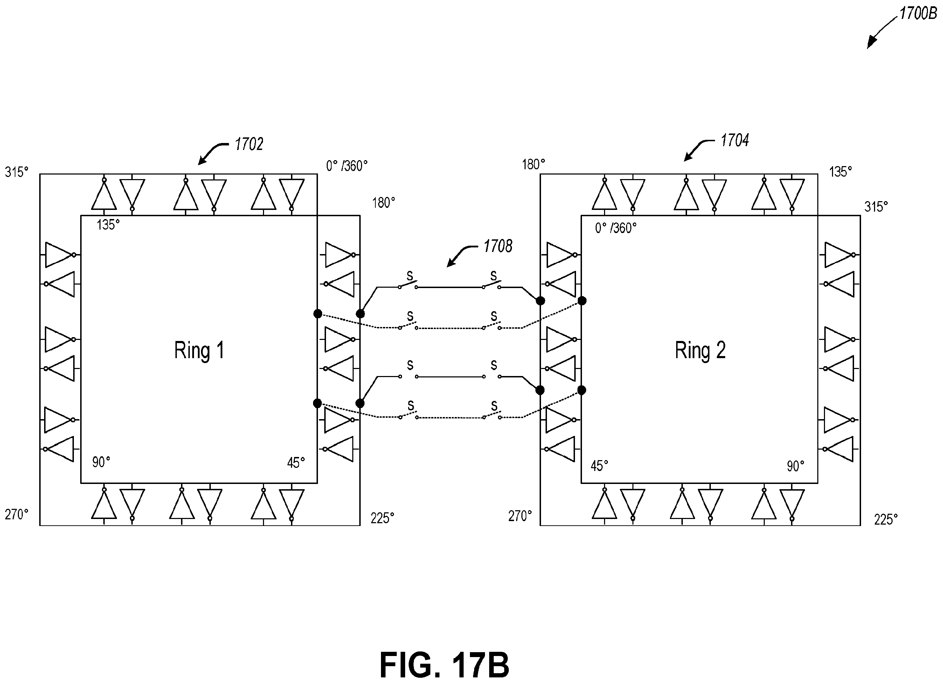

FIG. 17B is a block diagram 1700B illustrating a locking scheme for the two RTWO rings of FIG. 16A with the two rings shorted at two points, in accordance with some embodiments. Referring to FIG. 17B, RTWOs 1702 and 1704 can be coupled via high-speed interconnects 1708.

In some aspects, two RTWO rings are implemented on different chiplets are shown in FIG. 17A and FIG. 17B. The phase points on the inner and outer loop of the RTWO rings are marked in FIGS. 17A-17B. The two rings are connected with high-speed interconnects, and the connection between them is controlled with a transmission gate switch. Two differential phase points between the two rings are connected to ensure the traveling wave between the rings is in the same direction after synchronization. The shorting of the rings at the two differential points ensures that only one mode of oscillation is possible.

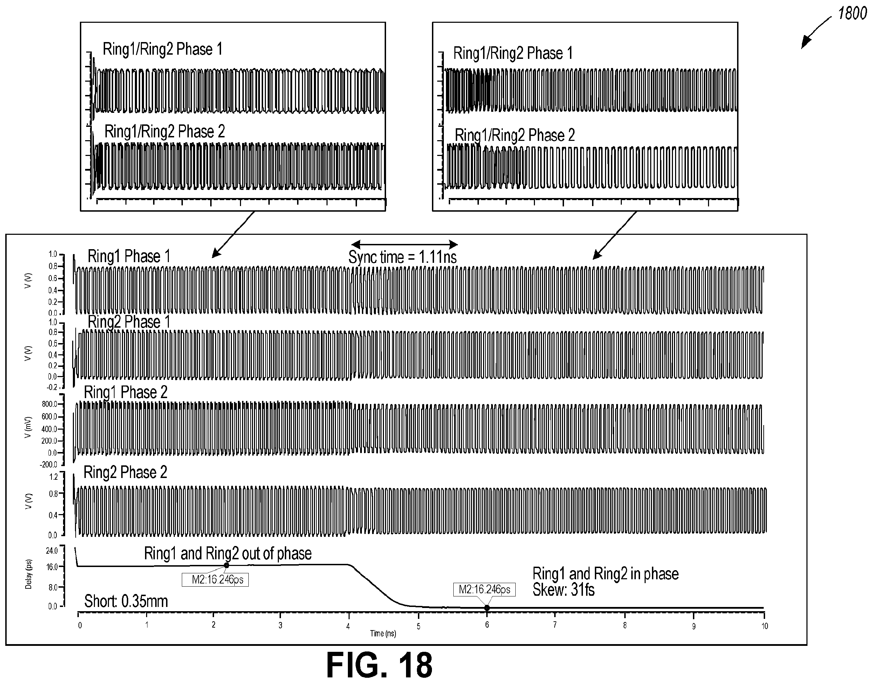

FIG. 18 is a graph 1800 of RTWO synchronization with two rings separated by 0.35 mm, in accordance with some embodiments. In FIG. 18, the simulation of two RTWO rings separated by 0.35mm is shown. The RTWO rings are implemented with the top metal layers, and the rings are shorted with high-speed interconnects. The simulations are performed with extracted models for the parasitics. The waveform at the bottom of FIG. 18 shows the simulation waveform of ~16 GHz resonant rings. Ring1 and Ring2, after initial start-up, oscillate in opposite directions (clockwise and counter-clockwise). After settling, when the two rings placed 0.35 mm apart are locked, it takes approximately 1.11 ns for the two rings to align in phase. The skew between the two rings after locking is 31 fs. During the synchronization phase, the traveling wave from Ring1 to Ring2 on the high-speed interconnect is in the standing wave mode, which is then recovered to the traveling wave mode upon reaching the destination and locking the wave direction. This provides a low skew between the rings. The two waveform snippets on the top show the clock alignment between Ring1 and Ring2 before and after synchronization.

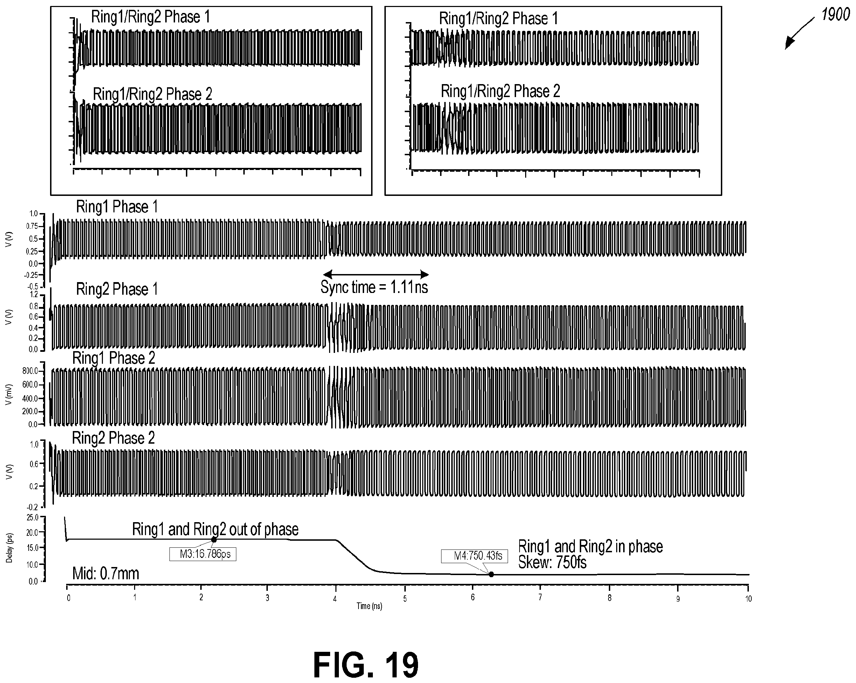

FIG. 19 is a graph 1900 of RTWO synchronization with two rings separated by 0.7 mm, in accordance with some embodiments. In FIG. 19, the simulation of two RTWO rings separated by 0.7mm is shown. The waveform on the bottom of FIG. 19 shows the simulation waveform of ~16 GHz resonant rings. Ring1 and Ring2, after initial start-up, oscillate in opposite directions (clockwise and counter-clockwise). After settling, when the two rings placed 0.7 mm apart are locked, it takes approximately 1.11 ns for the two rings to align in phase. The skew between the two rings after locking is 750 fs. During the synchronization phase, the traveling wave from Ring1 to Ring2 on the high-speed interconnect is in the standing wave mode, which is then recovered to the traveling wave mode upon reaching the destination and locking the wave direction. This provides a low skew between the rings. Further separation between the rings leads to amplitude distortion of the wave since there is no clock recovery or amplification circuit, and the velocity of the wave cannot be boosted.

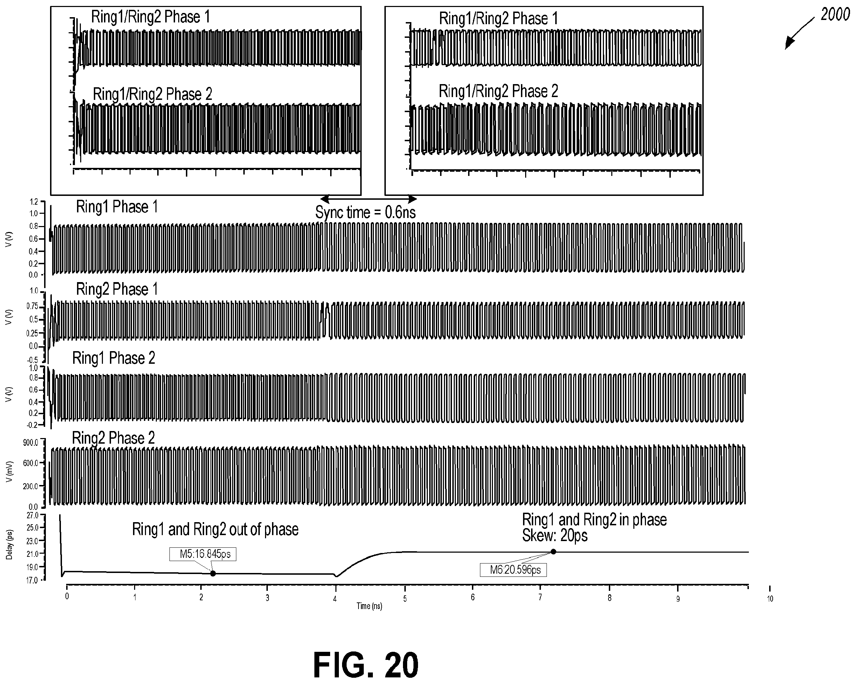

FIG. 20 is a graph 2000 of RTWO synchronization with two rings separated by 0.7 mm, in accordance with some embodiments.

To synchronize RTWOs that are placed further apart (1.4 mm), high-speed interconnects that can sustain the oscillation between the two rings are required. To implement this, the short between the two rings is implemented with high-speed clock buffers and interconnects. In FIG. 20, the simulation of two RTWO rings 1.4 mm apart is shown. The waveform on the bottom of FIG. 20 shows the simulation waveform of ~16 GHz resonant rings. Ring1 and Ring2, after initial start-up, oscillate in opposite directions (clockwise and counter-clockwise). After settling, when the two rings placed 0.7 mm apart are locked, it takes approximately 0.6 ns for the two rings to oscillate in the same direction. The skew between the two rings after locking is 20 ps. The skew between the rings is the insertion delay of the high-speed interconnect and clock buffers used to synchronize the two rings. The proposed scheme ensures that the direction of the traveling wave is consistent, and the phase points between the two rings are deterministic based on the delay of the high-speed interconnects between the two rings.

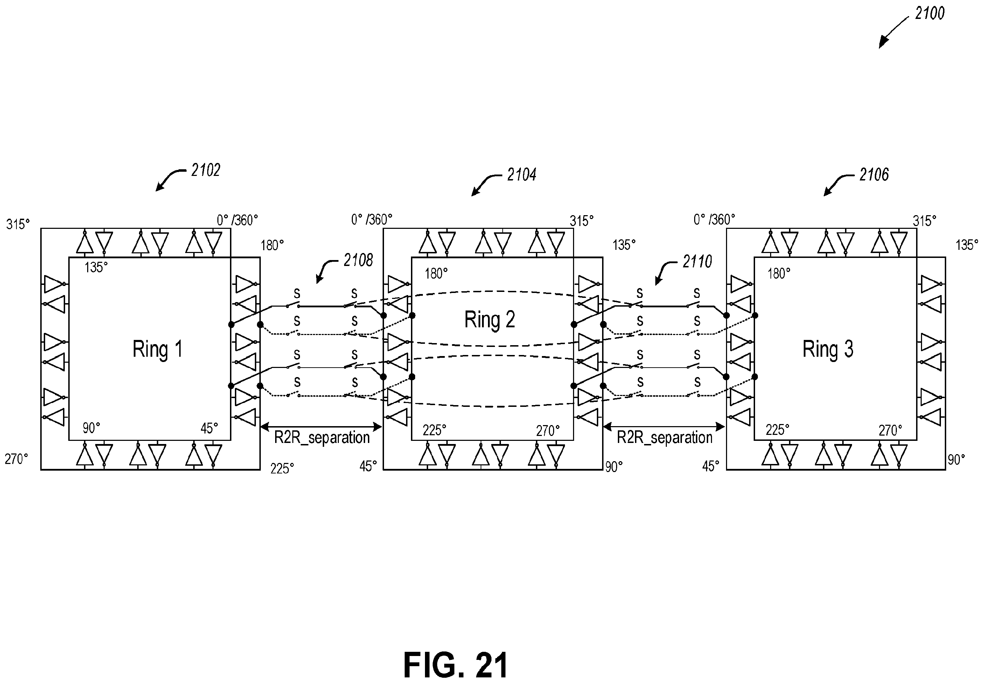

FIG. 21 is a block diagram of topology 2100 to connect multiple RTWO rings across different chiplets, in accordance with some embodiments. Referring to FIG. 21, topology 2100 includes RTWOs 2102, 2104, and 2106 coupled via high-speed interconnects 2108 and 2110.

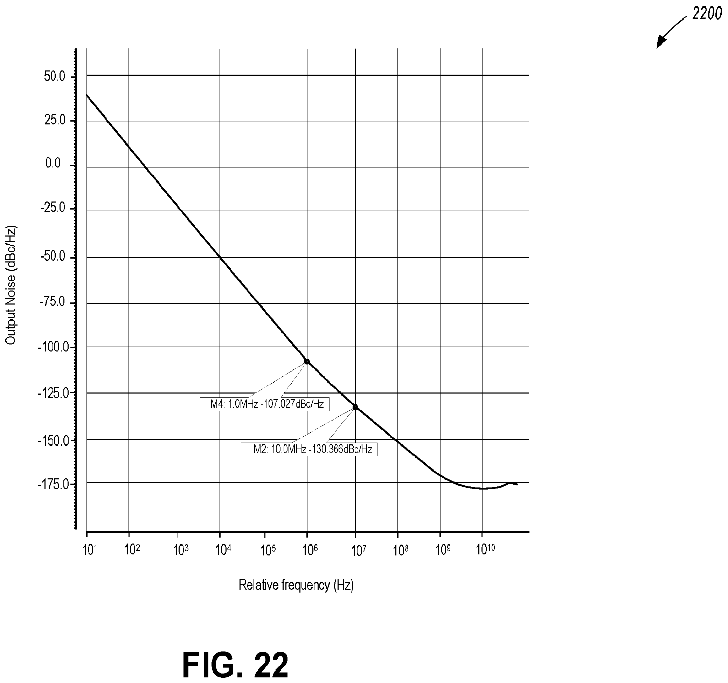

FIG. 22 is a graph 2200 of the phase of 16 GHz RTWO, in accordance with some embodiments.

In some aspects, the proposed architecture can be implemented to synchronize multiple RTWO rings placed on different chiplets, as shown in FIG. 21.

In FIG. 22, the phase noise of the RTWOs operating at 16 GHz is plotted. At 10 MHz, the phase noise of the RTWO is -130 dbc/Hz. The phase noise of the RTWOs is superior to that of other LC-based oscillators.

Scaling of compute resources, memory capacity, and communication channels on monolithic silicon (2D integration) have been the key limiters to achieving the performance target. Several memory computing solutions, along with architectural enhancements, have been shown to address this problem from the hardware design perspective. At the same time, 3D integration technology has the potential to solve the scaling needs. 3D integration/multi-tier approach for chip design is becoming a new norm in the semiconductor industry. Advanced 3D stacked systems for building edge/data-centric products are gaining traction in the industry. Further, graphics products are in need of a robust low-power, low-skew, and low-jitter clocking solution that can be scaled across various product segments such as Client Computing, Discrete Graphics, and High-Performance Computing. In addition to that, 3DIC-based graphics products are on the rise, which require high-frequency clock distributions across stacked dies. Designing a robust, high-speed, low-skew, low-jitter, and low-power clock across such 3D systems is highly challenging. Specifically, enabling clock synchronization for a stacked system (across multiple layers) is a critical challenge that can be resolved using the disclosed techniques.

In 3D stacked systems, cross-die process variations exacerbate the clock skews across different tiers. Furthermore, 3D integration leads to more thermal gradients and significant variations in inter-tier components, impacting clock skews and clock signal qualities. De-skew methods are challenging to implement in 3D integration due to the asymmetry of the clock distribution network and cross-tier variations. Typical 3D stacked systems have clock distribution networks for each tier, which are then tuned with phase comparators and tunable delay circuits to achieve bounded skew clock trees.

The disclosed techniques use a traveling wave-based resonant rotary clocking scheme for inter-tier synchronization in 3D stacked systems, leveraging feedthrough vias without the additional overhead of de-skew circuits.

FIG. 23 is a diagram of resonant clock synchronization across a 3D stacked system 2300, in accordance with some embodiments.

In some aspects, rotary oscillator arrays are implemented on each tier of a 3D stacked system. In some aspects, synchronization of the resonant clock across 3 tiers in a 3D stacked system can be achieved with feedthrough vias (e.g., as illustrated in FIG. 23).

The disclosed techniques can result in extremely low clock skew (of the order of fs) with resonant clock operating at a very high (multi-GHz) frequency. Example advantages of the disclosed techniques include:

(a) The overall implementation of resonant clocking structures on an interposer for synchronization across different tiers has been achieved and is not present in the prior art.

(b) Due to the phase/frequency alignment properties of resonant rotary clocking, it is possible to achieve clock synchronization and provide multiple phase points.

(c) As the traveling wave scheme provides deterministic delay, this can be used in D2D IOs. The resultant skew and jitter values with the proposed scheme are low (in the order of fs). It is challenging to achieve similar results with conventional schemes.

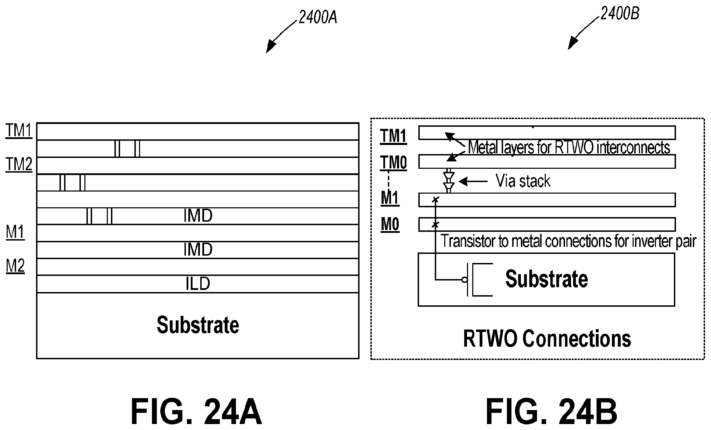

FIG. 24A is a diagram 2400A of a metal stack cross-section in a CMOS process, in accordance with some embodiments.

FIG. 24B is a diagram 2400B of RTWO connections, in accordance with some embodiments.

In some aspects, the building blocks of an RTWO are metal interconnects and CMOS inverter pairs. In some aspects, RTWOs are implemented with the top 2 metal layers to leverage the low resistance and thick metal layers. In FIG. 24A, a metal stack illustration of a conventional CMOS process is shown. In FIG. 24B, the layout connections between the inverter pairs and top metals layers with the via stack are shown. When the RTWOs are scaled across a die as an ROA, the corner of each ring is cross-connected at the corners in the top-metal layers, as shown in FIG. 23.

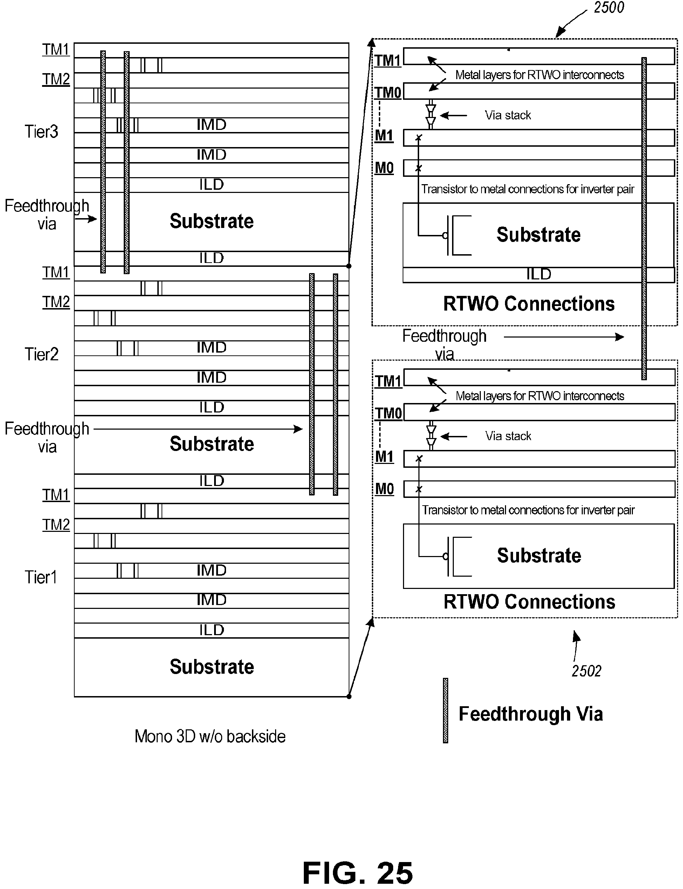

FIG. 25 is a diagram of a monolithic 3D stacked implementation 2500, showing detailed connections between top metal layers across tiers, in accordance with some embodiments.

In some aspects, a monolithic 3D stack with 3 tiers can be configured as shown in FIG. 25. The RTWOs are implemented on each tier using the top 2 metal layers and inverter pairs in each layer. The feedthrough via connections between each tier to connect the RTWOs are indicated in the legend in FIG. 23. Illustration 2502 details the connections between tier 1 and tier 2.

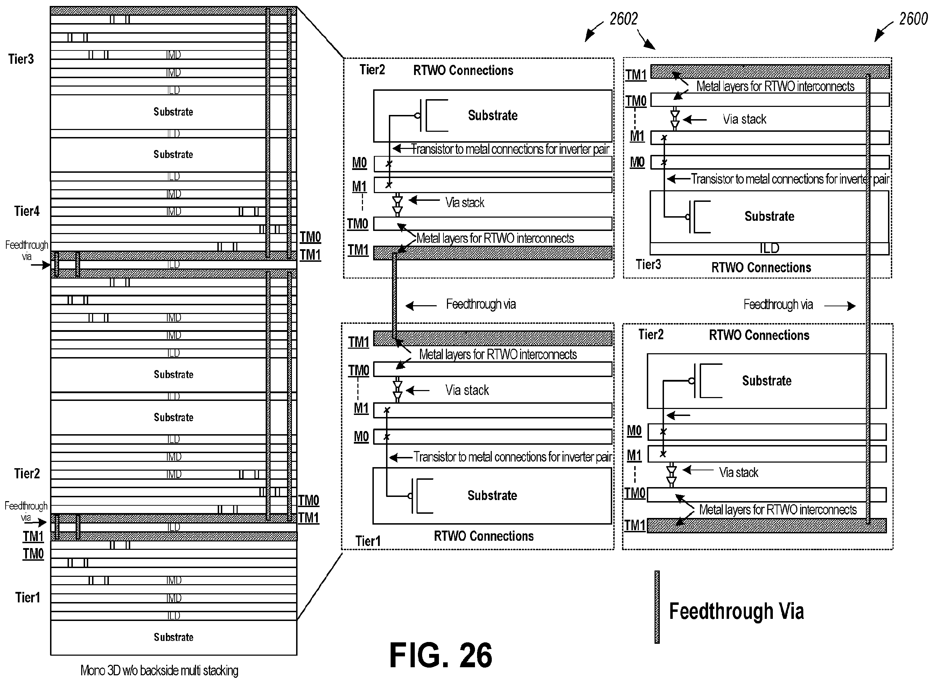

FIG. 26 is a diagram of a monolithic 3D stacked implementation 2600 with flipped tiers showing detailed connections between top metal layers across tiers, in accordance with some embodiments.

In some aspects, a monolithic 3D stack with 5 tiers with face-to-face stacking can be configured as shown in FIG. 26. The RTWOs are implemented on each tier using the top 2 metal layers and inverter pairs in each layer. The feedthrough via connections between each tier to connect the RTWOs are indicated in the legend in FIG. 26. Illustrations 2602 details the connections between tier 1 and tier 2, as well as between tier 2 and tier 3.

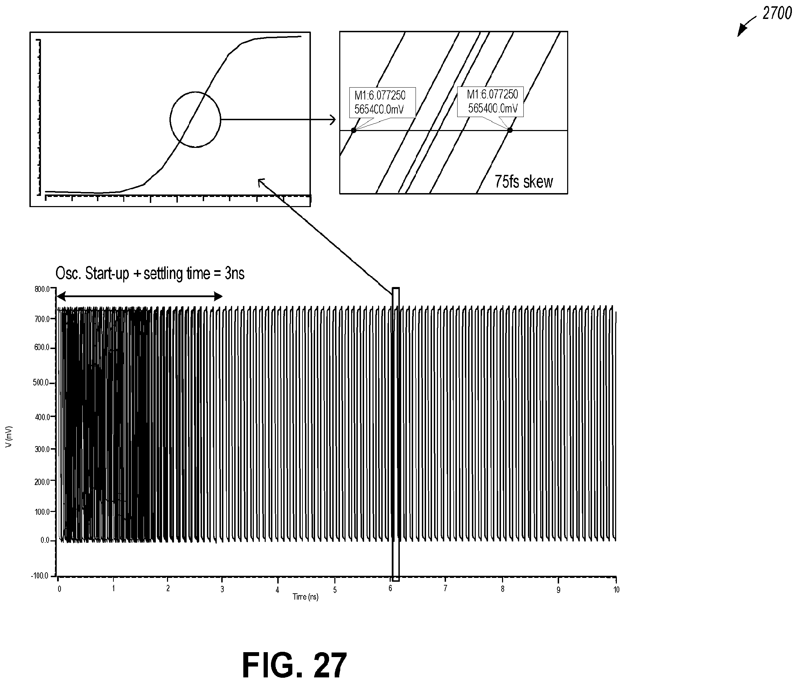

FIG. 27 is a graph 2700 of ROA synchronization and clock skew across three tiers, in accordance with some embodiments.

In some aspects, RTWOs are extracted and modeled using the top 2 metal layers and inverter pairs. For a given standard cell height, a feedthrough via resistance of ~40 $\Omega$ can be achieved. The top metal layers in a typical CMOS process are in the ranges of 1 um to 2 um. The feedthrough vias connect the top metal layers for the RTWOs modeled such that the resistance of each feedthrough connection is 20 $\Omega$.

In FIG. 27, the RTWO clock signal characteristics are shown. The RTWO frequency is 10 GHz, and each side of the RTWO ring is 1 mm. The ROA takes 3 ns to start up and settles at 10 GHz. The clock skew across the 3 tiers is shown on the top side of FIG. 27. The clock skew of the proposed resonant clocking architecture is 75 fs.

FIG. 28 illustrates a hybrid bonding-based IC solution 2800, in accordance with some embodiments. In FIG. 28, the hybrid bonded interconnect (HBI) based 3D integration can be used with the disclosed techniques. The HBI integration is a direct copper-to-copper sub10$\mu$m bonding between the top die/wafer and bottom die/wafer. This technology can provide more than 10x interconnect density improvement. A simulation-based study suggests that with HBIs smaller than 5um as part of the design, no additional overhead in the form of I/O drivers and ESD clamps is incurred. These low latency interconnects between the stacks enable novel circuit designs and architectures targeting high throughput with greater area and compute resource efficiency.

In 3D stacked systems, cross-die process variations exacerbate the clock skews across different tiers. Furthermore, 3D integration leads to more thermal gradients and significant variations in inter-tier components, impacting clock skews and clock signal qualities. De-skew methods are challenging to implement in 3D integration due to the asymmetry of the clock distribution network and cross-tier variations. Typical 3D stacked systems have clock distribution networks for each tier, which are then tuned with phase comparators and tunable delay circuits to achieve bounded skew clock trees.

The disclosed techniques include a traveling wave-based resonant rotary clocking scheme for inter-tier synchronization in 3D stacked systems leveraging hybrid bonded interconnect technology without the additional overhead of de-skew circuits. In some aspects, the RTWO can be configured as an ROA on each tier, which is then shorted with a feedthrough via for inter-tier synchronization.

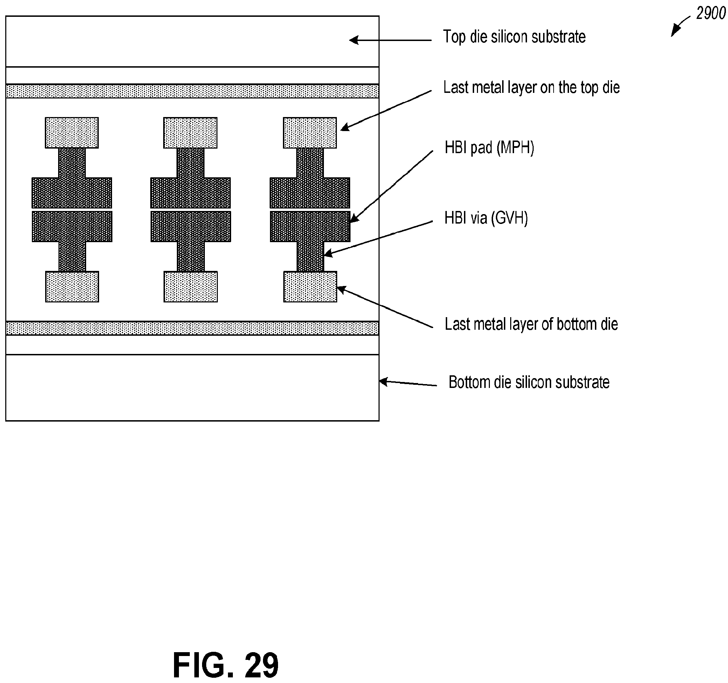

FIG. 29 is a diagram of a hybrid bonded interconnect (HBI) between face-to-face stacked 3D integration, in accordance with some embodiments. Referring to FIG. 29, the face-to-face HBI stack-up 2900 includes a top metal layer in the top die connected to the top metal layer in the bottom die. The HBI connection can be implemented using copper layers, which can be a direct copper-to-copper sub10$\mu$m bonding between the top die/wafer and bottom die/wafer. This technology can provide more than 10x interconnect density improvement.

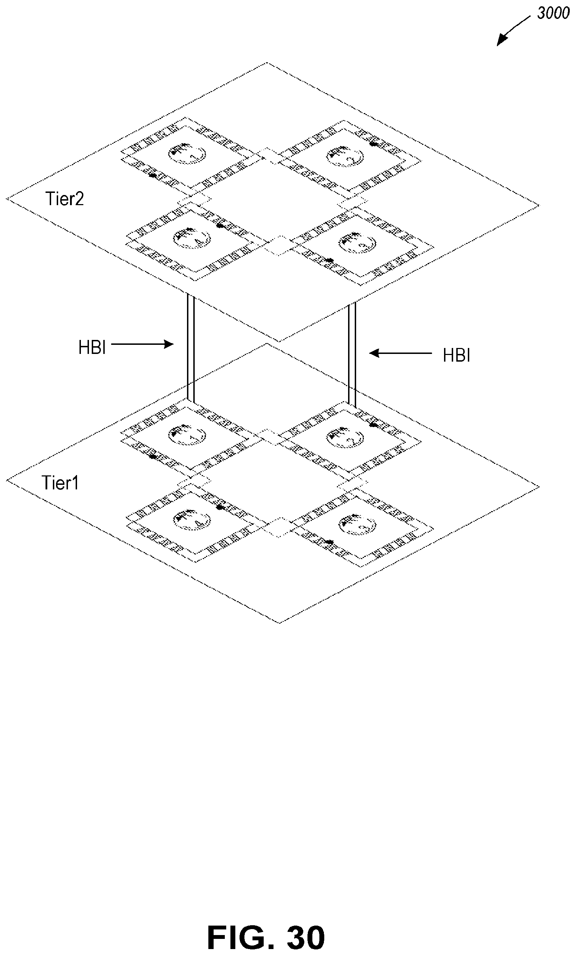

FIG. 30 is a diagram of resonant clock synchronization across a 3D stacked system 3000 with HBI, in accordance with some embodiments.

In some aspects, RTWOs can be configured with on-chip interconnects and inverter pairs that are terminated mobiusly to generate a resonating clock signal with a 50% duty cycle. In some aspects, rotary oscillator arrays are implemented on each tier of a 3D stacked system. In some aspects, synchronization of the resonant clock across two tiers in a 3D stacked system with hybrid bonded interconnects for the face-to-face connections can be configured as shown in FIG. 30. This configuration can result in low clock skew (of the order of fs) with resonant clock operating at a very high (multi-GHz) frequency. Some advantages associated with this configuration include:

    (a) An overall implementation of resonant clocking structures on an interposer for synchronization across different tiers, which is industry-first and academia-first.

(b) Due to the phase/frequency alignment properties of resonant rotary clocking, it is possible to achieve clock synchronization and provide multiple phase points.

(c) As the traveling wave scheme provides deterministic delay, this can be used in D2D IOs. The resultant skew and jitter values with the proposed scheme are low (in the order of fs). It can be challenging to achieve similar results with conventional schemes.

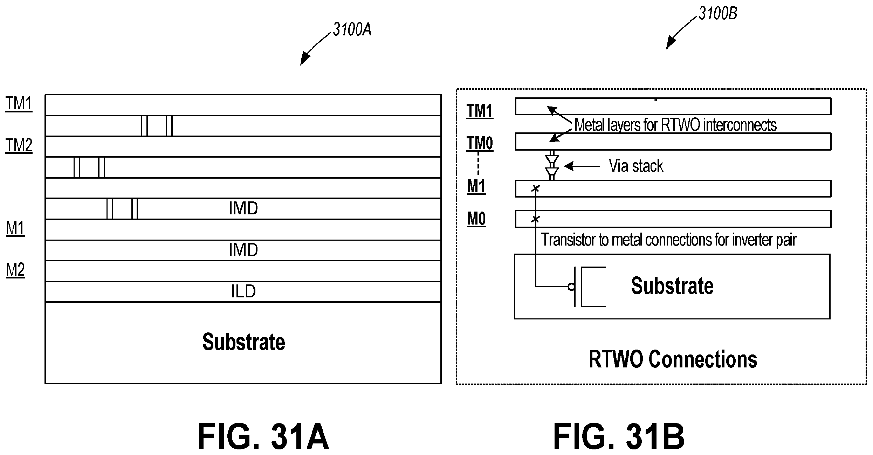

FIG. 31A is a diagram of a metal stack cross-section 3100A in a CMOS process, in accordance with some embodiments.

FIG. 31B is a diagram of RTWO connections 3100B, in accordance with some embodiments.

In some aspects, the building blocks of an RTWO can be configured based on metal interconnects and CMOS inverter pairs. In some aspects, RTWOs are implemented with the top 2 metal layers to leverage the low resistance and thick metal layers. In FIG. 31A, a metal stack illustration of a conventional CMOS process is shown. In FIG. 31B, the layout connections between the inverter pairs and top metals layers with the via stack are shown. When the RTWOs are scaled across a die as a ROA, the corner of each ring is cross-connected at the corners in the top-metal layers (e.g., as shown in FIG. 30).

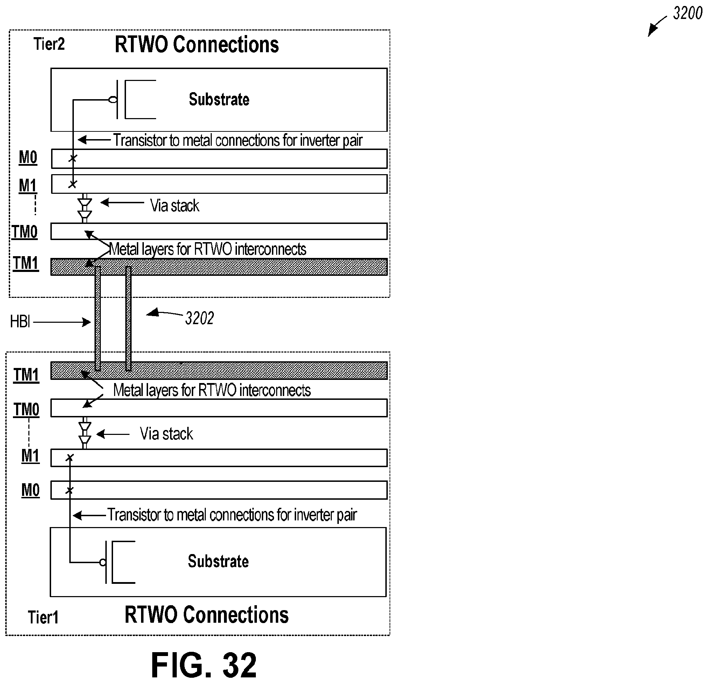

FIG. 32 is a diagram 3200 of HBI connections for RTWO between two tiers, in accordance with some embodiments.

In some aspects, a 2D stack with 2 tiers can be configured as illustrated in FIG. 32. The RTWOs can be implemented on each tier using the top 2 metal layers and inverter pairs in each layer. The HBI connections 3202 between each tier to connect the RTWOs are also illustrated in FIG. 32.

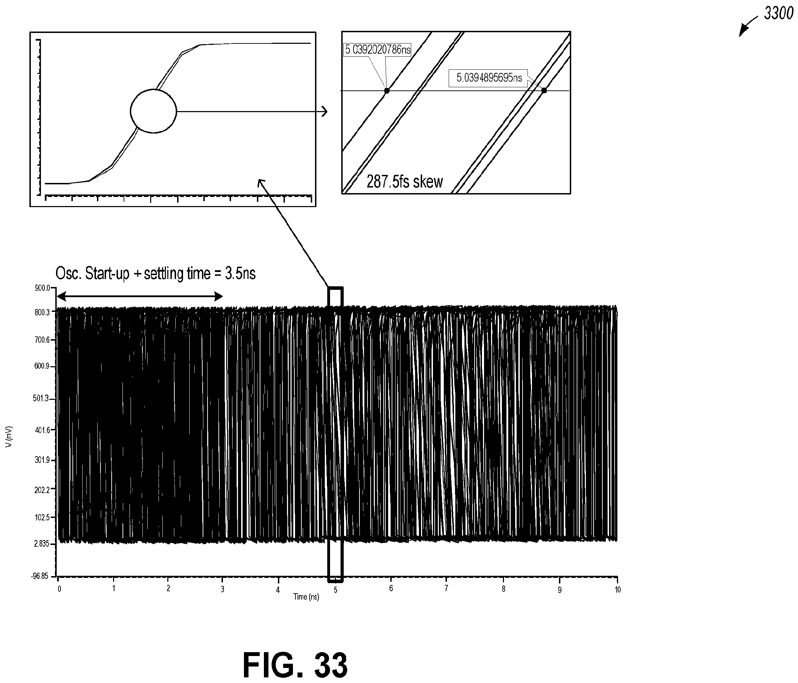

FIG. 33 is a graph 3300 of ROA synchronization and clock skew across two tiers, in accordance with some embodiments.

In some aspects, the RTWOs are extracted and modeled using the top 2 metal layers and inverter pairs. In some aspects, a hybrid bonding pitch of 9 um can be selected. In FIG. 33, the RTWO clock signal characteristics are shown. The RTWO frequency is 10 GHz, and each side of the RTWO ring is 1 mm. The ROA takes 3.5 ns to start up and settle at 10 GHz. The clock skew across the two tiers is shown on the top side of FIG. 33. The clock skew of the proposed resonant clocking architecture is 287.5 fs.

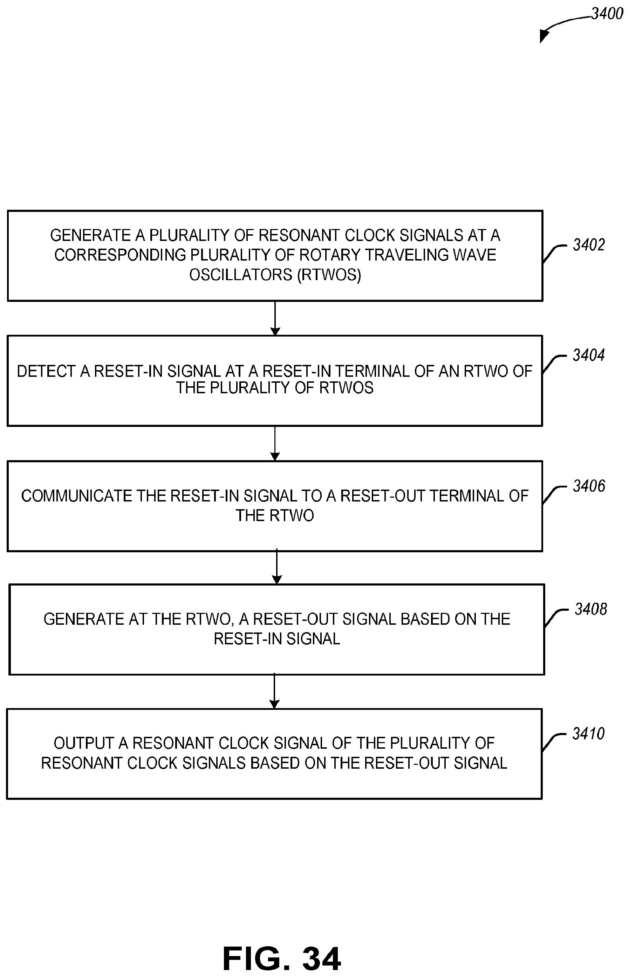

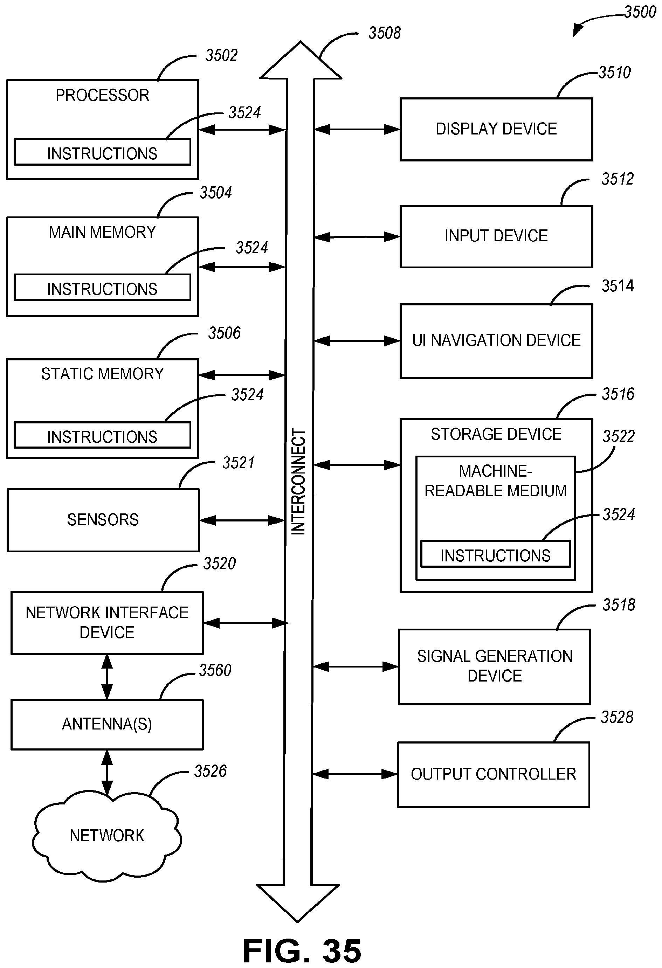

FIG. 34 is a flow diagram of an example method 3400 for generating synchronization signals, in accordance with some embodiments. Referring to FIG. 34, method 3400 includes operations 3402, 3404, 3406, 3408, and 3410, which may be executed by a processor, an embedded controller, a receiver circuit, a transceiver circuit, or another processor of a computing device (e.g., hardware processor 3502 of machine 3500 illustrated in FIG. 35, which can include one or more of the circuits discussed in connection with FIGS. 1-33). In some embodiments, one or more of the circuits discussed in connection with FIGS. 1-33 can perform the functionalities (or include the configurations or circuitry) associated with FIG. 34, as well as one or more of the examples listed below.

At operation 3402, a plurality of resonant clock signals is generated at a corresponding plurality of rotary traveling wave oscillators (RTWOs).

At operation 3404, a reset-in signal is detected at a reset-in terminal of an RTWO of the plurality of RTWOs.

At operation 3406, the reset-in signal is communicated to a reset-out terminal of the RTWO.

At operation 3408, a reset-out signal is generated at the RTWO based on the reset-in signal.

At operation 3410, a resonant clock signal of the plurality of resonant clock signals is output based on the reset-out signal.

FIG. 35 illustrates a block diagram of an example machine 3500 upon which any one or more of the techniques (e.g., methodologies) discussed herein may perform. In alternative embodiments, the machine 3500 may operate as a standalone device or may be connected (e.g., networked) to other machines. In a networked deployment, machine 3500 may operate in the capacity of a server machine, a client machine, or both in server-client network environments. In an example, machine 3500 may function as a peer machine in a peer-to-peer (P2P) (or other distributed) network environment. The machine 3500 may be a personal computer (PC), a tablet PC, a set-top box (STB), a personal digital assistant (PDA), a portable communications device, a mobile telephone, a smartphone, a web appliance, a network router, switch or bridge, or any other computing device capable of executing instructions (sequential or otherwise) that specify actions to be taken by that machine. Further, while only a single machine is illustrated, the term "machine" shall also be taken to include any collection of machines that individually or jointly execute a set (or multiple sets) of instructions to perform any one or more of the methodologies discussed herein, such as cloud computing, software as a service (SaaS), other computer cluster configurations. The terms "machine," "computing device," and "computer system" are used interchangeably.

Machine (e.g., computer system) 3500 may include a hardware processor 3502 (e.g., a central processing unit (CPU), a graphics processing unit (GPU), a hardware processor core, or any combination thereof), a main memory 3504, and a static memory 3506, some or all of which may communicate with each other via an interlink (e.g., bus) 3508. In some aspects, the main memory 3504, the static memory 3506, or any other type of memory (including cache memory) used by machine 3500 can be configured based on the disclosed techniques or can implement the disclosed memory devices.

Specific examples of main memory 3504 include random access memory (RAM) and semiconductor memory devices, which may include, in some embodiments, storage locations in semiconductors such as registers. Specific examples of static memory 3506 include non-volatile memory, such as semiconductor memory devices (e.g., electrically programmable read-only memory (EPROM), electrically erasable programmable read-only memory (EEPROM)) and flash memory devices; magnetic disks, such as internal hard disks and removable disks; magneto-optical disks; RAM; and CD-ROM and DVD-ROM disks.

Machine 3500 may further include a display device 3510, an input device 3512 (e.g., a keyboard), and a user interface (UI) navigation device 3514 (e.g., a mouse). In an example, the display device 3510, the input device 3512, and the UI navigation device 3514 may be a touchscreen display. The machine 3500 may additionally include a storage device (e.g., drive unit or another mass storage device) 3516, a signal generation device 3518 (e.g., a speaker), a network interface device 3520, and one or more sensors 3521, such as a global positioning system (GPS) sensor, compass, accelerometer, or other sensors. The machine 3500 may include an output controller 3528, such as a serial (e.g., universal serial bus (USB), parallel, or other wired or wireless (e.g., infrared (IR), near field communication (NFC), etc.) connection to communicate or control one or more peripheral devices (e.g., a printer, card reader, etc.). In some embodiments, the hardware processor 3502 and/or instructions 3524 may comprise processing circuitry and/or transceiver circuitry.

The storage device 3516 may include a machine-readable medium 3522 on which one or more sets of data structures or instructions 3524 (e.g., software) embodying or utilized by any one or more of the techniques or functions described herein can be stored. Instructions 3524 may also reside, completely or at least partially, within the main memory 3504, within static memory 3506, or the hardware processor 3502 during execution thereof by machine 3500. In an example, one or any combination of the hardware processor 3502, the main memory 3504, the static memory 3506, or the storage device 3516 may constitute machine-readable media.

Specific examples of machine-readable media may include non-volatile memory, such as semiconductor memory devices (e.g., EPROM or EEPROM) and flash memory devices; magnetic disks, such as internal hard disks and removable disks; magneto-optical disks; RAM; and CD-ROM and DVD-ROM disks.

While the machine-readable medium 3522 is illustrated as a single medium, the term "machine-readable medium" may include a single medium or multiple media (e.g., a centralized or distributed database and/or associated caches and servers) configured to store instructions 3524.

An apparatus of machine 3500 may be one or more of a hardware processor 3502 (e.g., a central processing unit (CPU), a graphics processing unit (GPU), a hardware processor core, or any combination thereof), a main memory 3504 and a static memory 3506, one or more sensors 3521, a network interface device 3520, one or more antennas 3560, a display device 3510, an input device 3512, a UI navigation device 3514, a storage device 3516, instructions 3524, a signal generation device 3518, and an output controller 3528. The apparatus may be configured to perform one or more of the methods and/or operations disclosed herein. The apparatus may be intended as a component of machine 3500 to perform one or more of the methods and/or operations disclosed herein and/or to perform a portion of one or more of the methods and/or operations disclosed herein. In some embodiments, the apparatus may include a pin or other means to receive power. In some embodiments, the apparatus may include power conditioning hardware.

The term "machine-readable medium" may include any medium that is capable of storing, encoding, or carrying instructions for execution by machine 3500 and that causes machine 3500 to perform any one or more of the techniques of the present disclosure, or that is capable of storing, encoding, or carrying data structures used by or associated with such instructions. Non-limiting machine-readable medium examples may include solid-state memories and optical and magnetic media. Specific examples of machine-readable media may include non-volatile memory, such as semiconductor memory devices (e.g., Electrically Programmable Read-Only Memory (EPROM), Electrically Erasable Programmable Read-Only Memory (EEPROM)) and flash memory devices; magnetic disks, such as internal hard disks and removable disks; magneto-optical disks; Random Access Memory (RAM); and CD-ROM and DVD-ROM disks. In some examples, machine-readable media may include non-transitory machine-readable media. In some examples, machine-readable media may include machine-readable media that is not a transitory propagating signal.

The instructions 3524 may further be transmitted or received over a communications network 3526 using a transmission medium via the network interface device 3520 utilizing any one of several transfer protocols (e.g., frame relay, internet protocol (IP), transmission control protocol (TCP), user datagram protocol (UDP), hypertext transfer protocol (HTTP), etc.). Example communication networks may include a local area network (LAN), a wide area network (WAN), a packet data network (e.g., the Internet), mobile telephone networks (e.g., cellular networks), plain old telephone (POTS) networks, and wireless data networks (e.g., Institute of Electrical and Electronics Engineers (IEEE) 802.11 family of standards known as Wi-Fi®, IEEE 802.16 family of standards known as WiMax®), IEEE 802.8.4 family of standards, a Long Term Evolution (LTE) family of standards, a universal mobile telecommunications system (UMTS) family of standards, peer-to-peer (P2P) networks, among others.

In an example, the network interface device 3520 may include one or more physical jacks (e.g., Ethernet, coaxial, or phone jacks) or one or more antennas to connect to the communications network 3526. In an example, the network interface device 3520 may include one or more antennas 3560 to wirelessly communicate using at least one single-input multiple-output (SIMO), multiple-input multiple-output (MIMO), or multiple-input single-output (MISO) techniques. In some examples, the network interface device 3520 may wirelessly communicate using multiple-user MIMO techniques. The term "transmission medium" shall be taken to include any intangible medium that can store, encode, or carry instructions for execution by machine 3500 and includes digital or analog communications signals or other intangible media to facilitate communication of such software.

Examples, as described herein, may include, or may operate on, logic or several components, modules, or mechanisms. Modules are tangible entities (e.g., hardware) capable of performing specified operations and may be configured or arranged in a particular manner. In an example, circuits may be arranged (e.g., internally or concerning external entities such as other circuits) in a specified manner as a module. In an example, the whole or part of one or more computer systems (e.g., a standalone, client, or server computer system) or one or more hardware processors may be configured by firmware or software (e.g., instructions, an application portion, or an application) as a module that operates to perform specified operations. In an example, the software may reside on a machine-readable medium. In an example, the software, when executed by the underlying hardware of the module, causes the hardware to perform the specified operations.

Accordingly, the term "module" is understood to encompass a tangible entity, be that an entity that is physically constructed, specifically configured (e.g., hardwired), or temporarily (e.g., transitorily) configured (e.g., programmed) to operate in a specified manner or to perform part, all, or any operation described herein. Considering examples in which modules are temporarily configured, each of the modules need not be instantiated at any one moment in time. For example, where the modules comprise a general-purpose hardware processor configured using the software, the general-purpose hardware processor may be configured as respective different modules at separate times. The software may accordingly configure a hardware processor, for example, to constitute a particular module at one instance of time and to constitute a different module at a different instance of time.

Some embodiments may be implemented fully or partially in software and/or firmware. This software and/or firmware may take the form of instructions contained in or on a non-transitory computer-readable storage medium. Those instructions may then be read and executed by one or more processors to enable the performance of the operations described herein. The instructions may be in any suitable form, such as but not limited to source code, compiled code, interpreted code, executable code, static code, dynamic code, and the like. Such a computer-readable medium may include any tangible non-transitory medium for storing information in a form readable by one or more computers, such as but not limited to read-only memory (ROM), random access memory (RAM), magnetic disk storage media, optical storage media, flash memory, etc.

The above-detailed description includes references to the accompanying drawings, which form a part of the detailed description. The drawings show, by way of illustration, specific embodiments that may be practiced. These embodiments are also referred to herein as "examples." Such examples may include elements in addition to those shown or described. However, examples that include the elements shown or described are also contemplated. Moreover, also contemplated are examples using any combination or permutation of those elements shown or described (or one or more aspects thereof), either with respect to a particular example (or one or more aspects thereof) or with respect to other examples (or one or more aspects thereof) shown or described herein.

Publications, patents, and patent documents referred to in this document are incorporated by reference herein in their entirety, as though individually incorporated by reference. In the event of inconsistent usage between this document and those documents so incorporated by reference, the usage in the incorporated reference(s) is supplementary to that of this document; for irreconcilable inconsistencies, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In the appended claims, the terms "including" and "in which" are used as the plain-English equivalents of the respective terms "comprising" and "wherein." Also, in the following claims, the terms "including" and "comprising" are open-ended, that is, a system, device, article, or process that includes elements in addition to those listed after such a term in a claim are still deemed to fall within the scope of that claim. Moreover, in the following claims, the terms "first," "second," and "third," etc., are used merely as labels and are not intended to suggest a numerical order for their objects.

The embodiments as described above may be implemented in various hardware configurations that may include a processor for executing instructions that perform the techniques described. Such instructions may be contained in a machine-readable medium such as a suitable storage medium or a memory or other processor-executable medium.

The embodiments as described herein may be implemented in several environments, such as part of a system on chip, a set of intercommunicating functional blocks, or similar, although the scope of the disclosure is not limited in this respect.

Described implementations of the subject matter can include one or more features, alone or in combination, as illustrated below by way of examples.

Example 1 is a rotary traveling wave oscillator (RTWO) comprising a plurality of inverter cells, the plurality of inverter cells being coupled in parallel to each other between two metal interconnects, and an inverter cell of the plurality of inverter cells comprising an inverter pair, the inverter pair being cross-coupled between the two metal interconnects; a coarse tuning capacitor coupled between the two metal interconnects; and a coarse tuning capacitor coupled between the two metal interconnects.

In Example 2, the subject matter of Example 1 includes subject matter where the two metal interconnects comprise a first backside metal layer and a second backside metal layer of a substrate.

In Example 3, the subject matter of Example 2 includes a fractional divider coupled to the two metal interconnects.

In Example 4, the subject matter of Example 3 includes a plurality of reset synchronization blocks and at least one reset synchronization block of the plurality of reset synchronization blocks coupled to the fractional divider.

In Example 5, the subject matter of Example 4 includes subject matter where a reset synchronization block of the plurality of reset synchronization blocks comprises a first flip-flop circuit coupled to a first data signal path and a second flip-flop circuit coupled to a second data signal path.

In Example 6, the subject matter of Example 5 includes subject matter where the first flip-flop circuit and the second flip-flop circuit are high-frequency flip-flop circuits.

In Example 7, the subject matter of Examples 5-6 includes subject matter where a reset synchronization block of the plurality of reset synchronization blocks further comprises a first set of buffer circuits coupled to the first flip-flop circuit and a second set of buffer circuits coupled to the second flip-flop circuit.

In Example 8, the subject matter of Example 7 includes subject matter where a reset synchronization block of the plurality of reset synchronization blocks further comprises a third set of buffer circuits coupled to the first flip-flop circuit via a first clock signal path and a fourth set of buffer circuits coupled to the second flip-flop circuit via a second clock signal path.

In Example 9, the subject matter of Examples 4-8 includes a reset-in terminal coupled to at least one of the plurality of reset synchronization blocks.

In Example 10, the subject matter of Example 9 includes a reset-out terminal coupled to at least one of the plurality of reset synchronization blocks and the fractional divider.

In Example 11, the subject matter of Examples 4-10 includes subject matter where the fractional divider and the plurality of reset synchronization blocks are coupled to at least one front side metal layer of the substrate.

In Example 12, the subject matter of Examples 4-11 includes subject matter where the RTWO comprises a system-on-chip (SoC), the SoC comprising an integrated circuit (IC) mounted on the substrate, the IC comprising at least one of the plurality of inverter cells, the fractional divider, and the plurality of reset synchronization blocks.

In Example 13, the subject matter of Example 12 includes subject matter where the SoC further comprises at least one connector and wherein the at least one connector conforms with at least one of Universal Serial Bus (USB), High-Definition Multimedia Interface (HDMI), Thunderbolt, Peripheral Component Interconnect Express (PCIe), and Ethernet specifications.

Example 14 is a rotary oscillator array (ROA) apparatus comprising a plurality of rotary traveling wave oscillators (RTWOs) configured to generate a plurality of resonant clock signals, an RTWO of the plurality of RTWOs comprising a plurality of inverter cells coupled in parallel to each other between two metal interconnects; and a fractional divider coupled to the two metal interconnects, the fractional divider to output a resonant clock signal of the plurality of resonant clock signals based on a reset-out signal generated by a reset-out terminal of the RTWO.

In Example 15, the subject matter of Example 14 includes subject matter where an inverter cell of the plurality of inverter cells of the RTWO comprises an inverter pair, the inverter pair being cross-coupled between the two metal interconnects; a coarse tuning capacitor coupled between the two metal interconnects; and a coarse tuning capacitor coupled between the two metal interconnects.

In Example 16, the subject matter of Examples 14-15 includes subject matter where the fractional divider is coupled at a pre-configured phase point of a plurality of phase points corresponding to the plurality of RTWOs.

In Example 17, the subject matter of Example 16 includes subject matter where the plurality of resonant clock signals at the plurality of phase points comprise equal clock signal phases.

In Example 18, the subject matter of Examples 14-17 includes subject matter where the two metal interconnects comprise a first backside metal layer and a second backside metal layer of a substrate.

In Example 19, the subject matter of Example 18 includes subject matter where the RTWO of the plurality of RTWOs comprises a plurality of reset synchronization blocks, at least one reset synchronization block of the plurality of reset synchronization blocks coupled to the fractional divider.

In Example 20, the subject matter of Example 19 includes subject matter where a reset synchronization block of the plurality of reset synchronization blocks comprises a first flip-flop circuit coupled to a first data signal path and a second flip-flop circuit coupled to a second data signal path.

In Example 21, the subject matter of Example 20 includes subject matter where the first flip-flop circuit and the second flip-flop circuit are high-frequency flip-flop circuits.

In Example 22, the subject matter of Example 21 includes subject matter where a reset synchronization block of the plurality of reset synchronization blocks further comprises a first set of buffer circuits coupled to the first flip-flop circuit and a second set of buffer circuits coupled to the second flip-flop circuit.

In Example 23, the subject matter of Example 22 includes subject matter where a reset synchronization block of the plurality of reset synchronization blocks further comprises a third set of buffer circuits coupled to the first flip-flop circuit via a first clock signal path and a fourth set of buffer circuits coupled to the second flip-flop circuit via a second clock signal path.

In Example 24, the subject matter of Examples 19-23 includes subject matter where the RTWO of the plurality of RTWOs comprises a reset-in terminal coupled to at least one of the plurality of reset synchronization blocks.

In Example 25, the subject matter of Example 24 includes subject matter where the RTWO of the plurality of RTWOs comprises the reset-out terminal, and wherein the reset-out terminal is coupled to the at least one of the plurality of reset synchronization blocks and the fractional divider.

In Example 26, the subject matter of Example 25 includes subject matter where the reset-in terminal is to receive a reset-in signal and communicate the reset-in signal to the reset-out terminal of one or more RTWOs of the plurality of RTWOs via corresponding one or more signal communication paths.

In Example 27, the subject matter of Example 26 includes the subject matter where the reset-out terminal is to generate the reset-out signal based on the reset-in signal.

In Example 28, the subject matter of Example 27 includes subject matter where the one or more signal communication paths are configured with equal signal delay associated with communication of the reset-in signal.

In Example 29, the subject matter of Examples 19-28 includes subject matter where the fractional divider and the plurality of reset synchronization blocks are coupled to at least one front side metal layer of the substrate.

In Example 30, the subject matter of Examples 14-29 includes subject matter where the plurality of RTWOs is configured as a rectangular rotary traveling wave oscillator (RRTWO) in a D2D architecture.

In Example 31, the subject matter of Example 30 includes subject matter where the RRTWO is configured on a chiplet or a base die, the chiplet or the base die comprising UCIe-compliant die-to-die interfaces.

In Example 32, the subject matter of Example 31 includes subject matter where the ROA is a rectangular rotary oscillator array (RROA) comprising a plurality of RRTWOs, wherein the RROA is to perform chiplet-to-chiplet synchronization based on multiple phase points across the base die.

In Example 33, the subject matter of Examples 14-32 includes subject matter where at least two of the plurality of RTWOs are coupled to each other with at least one feedthrough via.

In Example 34, the subject matter of Examples 14-33 includes subject matter where at least two of the plurality of RTWOs are coupled to each other with at least one hybrid bonded interconnect (HBI).

In Example 35, the subject matter of Examples 19-34 includes subject matter where the ROA apparatus comprises a system-on-chip (SoC), the SoC comprising an integrated circuit (IC) mounted on the substrate, the IC comprising at least one of the plurality of inverter cells of one or more of the plurality of RTWOs, the fractional divider of one or more of the plurality of RTWOs, and the plurality of reset synchronization blocks of one or more of the plurality of RTWOs.

In Example 36, the subject matter of Example 35 includes subject matter where the SoC further comprises at least one connector and wherein the at least one connector conforms with at least one of Universal Serial Bus (USB), High-Definition Multimedia Interface (HDMI), Thunderbolt, Peripheral Component Interconnect Express (PCIe), and Ethernet specifications.

Example 37 is a method for generating synchronization signals, the method comprising generating a plurality of resonant clock signals at a corresponding plurality of rotary traveling wave oscillators (RTWOs), detecting a reset-in signal at a reset-in terminal of an RTWO of the plurality of RTWOs; communicating the reset-in signal to a reset-out terminal of the RTWO; generating at the RTWO, a reset-out signal based on the reset-in signal; and output a resonant clock signal of the plurality of resonant clock signals based on the reset-out signal.

Example 38 is at least one machine-readable medium including instructions that, when executed by processing circuitry, cause the processing circuitry to perform operations to implement any of Examples 1-37.

Example 39 is an apparatus comprising means to implement any of Examples 1-37.

Example 40 is a system to implement any of Examples 1-37.

Example 41 is a method to implement any of Examples 1-37.

The above description is intended to be illustrative and not restrictive. For example, the above-described examples (or one or more aspects thereof) may be used in combination with others. Other embodiments may be used, such as by one of ordinary skill in the art upon reviewing the above description. The abstract is to allow the reader to ascertain the nature of the technical disclosure quickly. It is submitted with the understanding that it will not be used to interpret or limit the scope or meaning of the claims. Also, in the above Detailed Description, various features may be grouped to streamline the disclosure. However, the claims may not set forth every feature disclosed herein as embodiments may feature a subset of said features. Further, embodiments may include fewer features than those disclosed in a particular example. Thus, the following claims are hereby incorporated into the Detailed Description, with a claim standing on its own as a separate embodiment. The scope of the embodiments disclosed herein is to be determined regarding the appended claims, along with the full scope of equivalents to which such claims are entitled.

**Claims**

1. A rotary traveling wave oscillator (RTWO) comprising:
   a plurality of inverter cells, the plurality of inverter cells being coupled in parallel to each other between two metal interconnects, and an inverter cell of the plurality of inverter cells comprising:

   an inverter pair, the inverter pair being cross-coupled between the two metal interconnects;
   a coarse tuning capacitor coupled between the two metal interconnects; and
   a coarse tuning capacitor coupled between the two metal interconnects.

2. The RTWO of claim 1, wherein the two metal interconnects comprise a first backside metal layer and a second backside metal layer of a substrate.

3. The RTWO of claim 2, further comprising:
   a fractional divider coupled to the two metal interconnects.

4. The RTWO of claim 3, further comprising:
   a plurality of reset synchronization blocks, at least one reset synchronization block of the plurality of reset synchronization blocks coupled to the fractional divider.

5. The RTWO of claim 4, wherein a reset synchronization block of the plurality of reset synchronization blocks comprises:

   a first flip-flop circuit coupled to a first data signal path; and
   a second flip-flop circuit coupled to a second data signal path.

6. The RTWO of claim 5, wherein a reset synchronization block of the plurality of reset synchronization blocks further comprises:

   a first set of buffer circuits coupled to the first flip-flop circuit; and
   a second set of buffer circuits coupled to the second flip-flop circuit.

7. The RTWO of claim 4, wherein the fractional divider and the plurality of reset synchronization blocks are coupled to at least one front side metal layer of the substrate.

8. The RTWO of any of claims 1-7, wherein the RTWO comprises a system-on-chip (SoC), the SoC comprising an integrated circuit (IC) mounted on the substrate, the IC comprising at least one of: the plurality of inverter cells, the fractional divider, and the plurality of reset synchronization blocks.

9. The RTWO of claim 8, wherein the SoC further comprises at least one connector, and wherein the at least one connector conforms with at least one of Universal Serial Bus (USB), High-Definition Multimedia Interface (HDMI), Thunderbolt, Peripheral Component Interconnect Express (PCIe), and Ethernet specifications.

10. A rotary oscillator array (ROA) apparatus comprising:
    a plurality of rotary traveling wave oscillators (RTWOs) configured to generate a plurality of resonant clock signals, an RTWO of the plurality of RTWOs being an RTWO of any one of claims 1 to 9 and comprising:

    a plurality of inverter cells coupled in parallel to each other between two metal interconnects; and
    a fractional divider coupled to the two metal interconnects, the fractional divider to output a resonant clock signal of the plurality of resonant clock signals based on a reset-out signal generated by a reset-out terminal of the RTWO.

11. The ROA apparatus of claim 10, wherein the two metal interconnects comprise a first backside metal layer and a second backside metal layer of a substrate.

12. The ROA apparatus of claim 11, wherein the RTWO of the plurality of RTWOs comprises:

a plurality of reset synchronization blocks, at least one reset synchronization block of the plurality of reset synchronization blocks coupled to the fractional divider; and
a reset-in terminal coupled to at least one of the plurality of reset synchronization blocks.

13. A method for generating synchronization signals, the method comprising:

generating a plurality of resonant clock signals at a corresponding plurality of rotary traveling wave oscillators (RTWOs);
detecting a reset-in signal at a reset-in terminal of an RTWO of the plurality of RTWOs; and
communicating the reset-in signal to a reset-out terminal of the RTWO.

14. The method of claim 13, further comprising:

generating at the RTWO, a reset-out signal based on the reset-in signal; and
output a resonant clock signal of the plurality of resonant clock signals based on the reset-out signal.

**FIG. 1**

**FIG. 2A**

**FIG. 2B**

EP 4 671 911 A1

FIG. 3

**FIG. 4A**

FIG. 4B

Frontside Metal (FM)

506 — Frontside Metal Layers

IMD

IMD

ILD

502

Substrate

504 — Backside Metal (BM) Layers

Backside Metal (BM)

500A

EP 4 671 911 A1

FIG. 5A

**FIG. 5B**

**FIG. 6**

Legend:
- ─── : DATA PATH
- ─── : CLOCK PATH
- ● : SAME PHASE POINT ON A RING
- ■ : FLIP-FLOP

FIG. 7

EP 4 671 911 A1

**FIG. 8**

EP 4 671 911 A1

**FIG. 9**

EP 4 671 911 A1

**FIG. 10**

EP 4 671 911 A1

**FIG. 11**

**FIG. 12B**

**FIG. 12A**

**FIG. 13**

EP 4 671 911 A1

**FIG. 14**

EP 4 671 911 A1

FIG. 15

FIG. 16

**FIG. 17A**

EP 4 671 911 A1

**FIG. 17B**

EP 4 671 911 A1

FIG. 18

FIG. 19

FIG. 20

**FIG. 21**

EP 4 671 911 A1

**FIG. 22**

EP 4 671 911 A1

2300

Tier3

Feedthrough
via

Feedthrough
via

Tier2

Feedthrough
via

Feedthrough
via

Tier1

# FIG. 23

FIG. 24A

FIG. 24B

**FIG. 25**

Tier3

Substrate

Substrate

Tier4

Feedthrough via → TM0 / TM1

Substrate

Substrate

Tier2 → TM0 / TM1

Feedthrough via → TM1 / TM0

Tier1

Substrate

Mono 3D w/o backside multi stacking

**Tier2    RTWO Connections**

Substrate

M0 — Transistor to metal connections for inverter pair

M1

— Via stack

TM0

TM1 — Metal layers for RTWO interconnects

← Feedthrough via

**2602**

TM1 — Metal layers for RTWO interconnects

TM0

— Via stack

M1

M0 — Transistor to metal connections for inverter pair

Substrate

**Tier1    RTWO Connections**

**2600**

TM1 — Metal layers for RTWO interconnects

TM0

M1 — Via stack

M0 — Transistor to metal connections for inverter pair

Substrate

ILD

**Tier3    RTWO Connections**

Feedthrough via →

**Tier2    RTWO Connections**

Substrate

M0

M1 — Via stack

TM0 — Metal layers for RTWO interconnects

TM1

**Feedthrough Via**

# FIG. 26

EP 4 671 911 A1

FIG. 27

FIG. 28

FIG. 29

*3000*

Tier2

HBI

HBI

Tier1

# FIG. 30

FIG. 31A

FIG. 31B

EP 4 671 911 A1

FIG. 32

FIG. 33

_3400

GENERATE A PLURALITY OF RESONANT CLOCK SIGNALS AT A CORRESPONDING PLURALITY OF ROTARY TRAVELING WAVE OSCILLATORS (RTWOS) ⟋ 3402

DETECT A RESET-IN SIGNAL AT A RESET-IN TERMINAL OF AN RTWO OF THE PLURALITY OF RTWOS ⟋ 3404

COMMUNICATE THE RESET-IN SIGNAL TO A RESET-OUT TERMINAL OF THE RTWO ⟋ 3406

GENERATE AT THE RTWO, A RESET-OUT SIGNAL BASED ON THE RESET-IN SIGNAL ⟋ 3408

OUTPUT A RESONANT CLOCK SIGNAL OF THE PLURALITY OF RESONANT CLOCK SIGNALS BASED ON THE RESET-OUT SIGNAL ⟋ 3410

# FIG. 34

**FIG. 35**

| | Europäisches Patentamt European Patent Office Office européen des brevets | **EUROPEAN SEARCH REPORT** | **Application Number** EP 25 17 7640 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2005/225365 A1 (WOOD JOHN [US])<br>13 October 2005 (2005-10-13)<br>* paragraphs [0008], [0030], [0043], [0059], [0233], [0376], [0530], [0566]; figures 1,3,11 * | 1,3-10, 12-14<br>2,11 | INV.<br>G06F1/10<br>H03B5/18<br>H03B5/20 |
| A | US 2018/102782 A1 (SHANAN HYMAN [US])<br>12 April 2018 (2018-04-12)<br>* paragraph [0147]; figures 1,3,7,11 * | 1-14 | |
| A | US 8 278 982 B2 (BECCUE STEPHEN MARK [US]; ANALOG DEVICES INC [US])<br>2 October 2012 (2012-10-02)<br>* figures 3A,3B * | 1-14 | |
| A | US 2022/247396 A1 (SHEHATA MOHAMED A [IE] ET AL) 4 August 2022 (2022-08-04)<br>* paragraph [0091]; figures 2A,2B,6 * | 1-14 | |

| TECHNICAL FIELDS SEARCHED (IPC) |
|---|
| G06F<br>H03K<br>H03D<br>H03B |

The present search report has been drawn up for all claims

| Place of search | Date of completion of the search | Examiner |
|---|---|---|
| Munich | 13 October 2025 | Boudet, Joachim |

EPO FORM 1503 03.82 (P04C01)

## ANNEX TO THE EUROPEAN SEARCH REPORT
## ON EUROPEAN PATENT APPLICATION NO.

EP 25 17 7640

This annex lists the patent family members relating to the patent documents cited in the above-mentioned European search report.
The members are as contained in the European Patent Office EDP file on
The European Patent Office is in no way liable for these particulars which are merely given for the purpose of information.

13-10-2025

| Patent document cited in search report | | Publication date | Patent family member(s) | | Publication date |
|---|---|---|---|---|---|
| US 2005225365 | A1 | 13-10-2005 | AU 2003208422 A1 | | 04-09-2003 |
| | | | CA 2476379 A1 | | 21-08-2003 |
| | | | CN 1647012 A | | 27-07-2005 |
| | | | EP 1476801 A2 | | 17-11-2004 |
| | | | GB 2403045 A | | 22-12-2004 |
| | | | GB 2419437 A | | 26-04-2006 |
| | | | KR 20040105721 A | | 16-12-2004 |
| | | | US 2005225365 A1 | | 13-10-2005 |
| | | | WO 03069452 A2 | | 21-08-2003 |
| US 2018102782 | A1 | 12-04-2018 | US 2018102782 A1 | | 12-04-2018 |
| | | | US 2019280701 A1 | | 12-09-2019 |
| US 8278982 | B2 | 02-10-2012 | NONE | | |
| US 2022247396 | A1 | 04-08-2022 | NONE | | |

EPO FORM P0459

For more details about this annex : see Official Journal of the European Patent Office, No. 12/82